# EUROPEAN PATENT SPECIFICATION

(11) **EP 2 551 274 B1**
(45) Date of publication and mention of the grant of the patent: **09.12.2015**
(21) Application number: 12177646.2
(22) Date of filing: 24.07.2012
(51) Int. Cl.: C07F 15/00, C09K 11/06, H01L 51/50

(54) **Tetradentate platinum complexes**
Tetradentat-Platin-Komplexe
Complexes tétradentelés de platine

(30) Priority: 25.07.2011 US 201161511385 P; 30.09.2011 US 201161541769 P
(43) Date of publication of application: 30.01.2013
(73) Proprietor: Universal Display Corporation, Ewing, NJ 08618 (US)
(72) Inventor: Kottas, Gregg, Ewing, NJ New Jersey 08618 (US); Fiordeliso, James, Ewing, NJ New Jersey 08618 (US); Ma, Bin, Ewing, NJ New Jersey 08618 (US); Xia, Chuanjun, 08618, NJ New Jersey Ewing (US)
(74) Representative: Maiwald Patentanwalts GmbH

(56) References cited:
- EP-A1- 2 123 640
- US-A1- 2009 198 069

## Description

The claimed invention was made by, on behalf of, and/or in connection with one or more of the following parties to a joint university corporation research agreement: Regents of the University of Michigan, Princeton University, The University of Southern California, and the Universal Display Corporation. The agreement was in effect on and before the date the claimed invention was made, and the claimed invention was made as a result of activities undertaken within the scope of the agreement.

### FIELD OF THE INVENTION

The present invention relates to compounds suitable for incorporation into OLED devices, specifically the compounds comprise tetradentate platinum complexes.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety. EP 2 123 640 A1 and US 2009/0198069 disclose platinum complexes useful in a light emitting device.

One application for phosphorescent emissive molecules is a full color display. Industry standards for such a display call for pixels adapted to emit particular colors, referred to as "saturated" colors. In particular, these standards call for saturated red, green, and blue pixels. Color may be measured using CIE coordinates, which are well known to the art.

One example of a green emissive molecule is tris(2-phenylpyridine) iridium, denoted Ir(ppy)₃, which has the following structure:

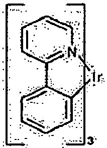

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704.

### SUMMARY OF THE INVENTION

A compound having the formula: 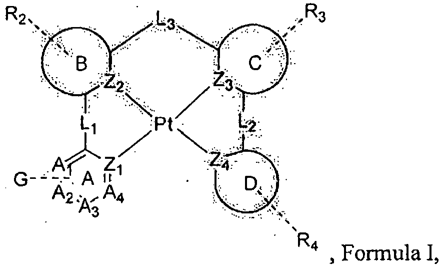 is provided, wherein G has the structure 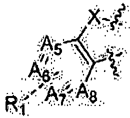 and wherein G is fused to any two adjacent carbon atoms on ring A. Ring B, ring C, and ring D are 5- or 6-membered carbocyclic or heterocyclic aromatic rings. L₁, L₂, and L₃ are independently selected from the group consisting of a single bond, BR, NR, PR, O, S, Se, C=O, S=O, SO₂, CRR', SiRR', and GeRR'. At least one of L₁, L₂, and L₃ is not a single bond, and X is selected from the group consisting of BR, NR, PR, O, S, Se, C=O, S=O, SO₂, CRR', SiRR', and GeRR'. Z₁, Z₂, Z₃, and Z₄ are nitrogen or carbon atoms, and A₁, A₂, A₃, A₄, A₅, A₆, A₇, and A₈ comprise carbon or nitrogen. R₁, R₂, R₃, and R₄ independently represent mono-, di-, tri-, or tetra-substitution, wherein R₁ is optionally fused, R₂ is optionally fused to ring B, R₃ is optionally fused to ring C, and R₄ is optionally fused to ring D. R₃ and R₄ are optionally linked to form a ring. If L₂ is not a single bond, R₃ and L₂ or R₄ and L₂ are optionally linked to form a ring. R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one embodiment, the compound has a neutral charge. In one embodiment, at least two of Z₁, Z₂, Z₃, and Z₄ are nitrogen atoms. In another embodiment, at least two of Z₁, Z₂, Z₃, and Z₄ are carbon atoms.

In one embodiment, at least one of ring B, ring C, and ring D comprises a carbene ligand coordinated to Pt. In another embodiment, at least one of Z₁, A₁, A₂, A₃, A₄, A₅, A₆, A₇, and A₈ is a nitrogen atom.

In one embodiment, the compound has the formula:

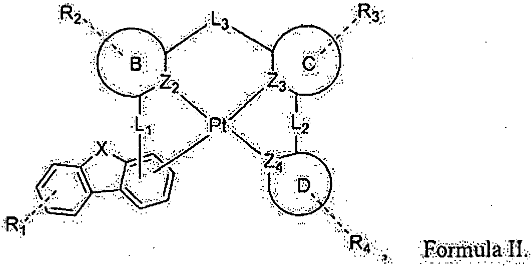

In another embodiment, the compound has the formula:

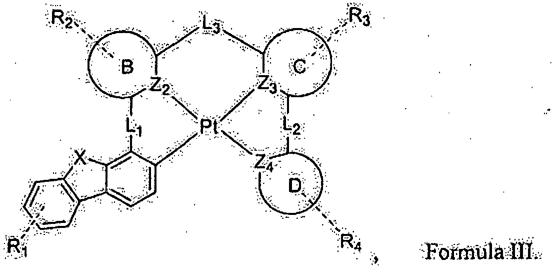

In one embodiment, the compound has the formula: 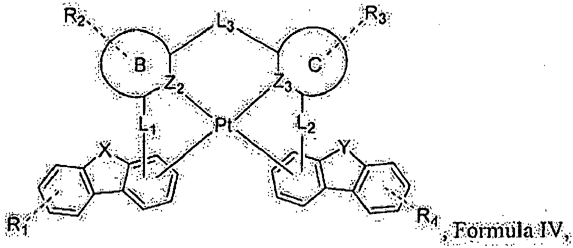 wherein Y is selected from the group consisting of BR, NR, PR, O, S, Se, C=O, S=O, SO₂, CRR', SiRR', and GeRR'.

In another embodiment, the compound has the formula:

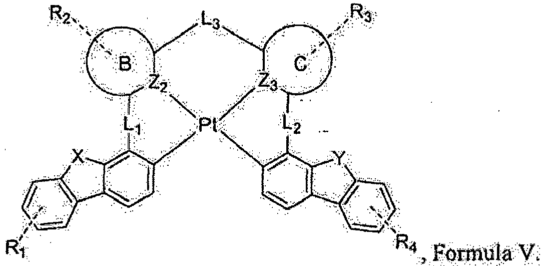

In one embodiment, L₁ and L₂ are single bonds. In another embodiment, L₃ is independently selected from the group consisting of O, S, and NR. In another embodiment, L₃ is NR, and R is phenyl or substituted phenyl. In one embodiment, L₃ is O.

In one embodiment, Z₂ and Z₃ are nitrogen atoms. In another embodiment, Z₂ and Z₄ are nitrogen atoms. In one embodiment, X is independently selected from the group consisting of O, S, and NR. In one embodiment, X is O.

In one embodiment, the compound is selected from the group consisting of: 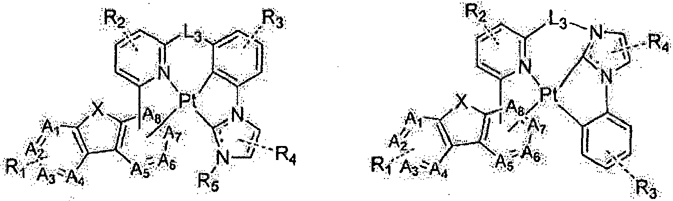 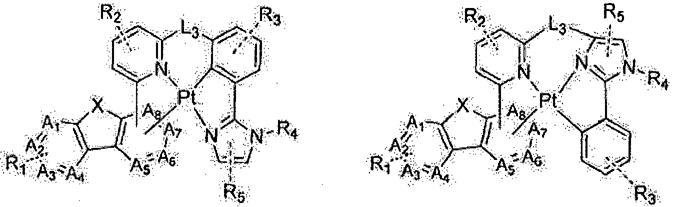 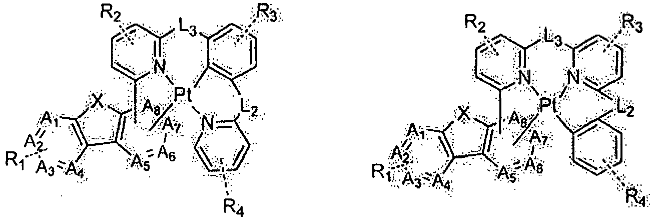 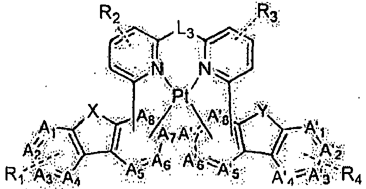 wherein Y is selected from the group consisting of BR, NR, PR, O, S, Se, C=O, S=O, SO₂, CRR', SiRR', and GeRR'. A₁', A₂', A₃', A₄', A₅', A₆', A₇', and A₈' comprise carbon or nitrogen. At most one of A₁, A₂, A₃, A₄ is nitrogen, and at most one of A₁', A₂', A₃', A₄' is nitrogen. At most one of A₅, A₆, A₇, A₈ is nitrogen, and the nitrogen is not bound to Pt. At most one of A₅', A₆', A₇', A₈' is nitrogen, and the nitrogen is not bound to Pt. The Pt forms at least two Pt-C bonds and R₃ and R₄ may be fused together to form a ring. R₅ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

A first device is provided. The first device comprises a first organic light emitting device, further comprising an anode, a cathode, and an organic layer, disposed between the anode and the cathode, comprising a compound having the formula: 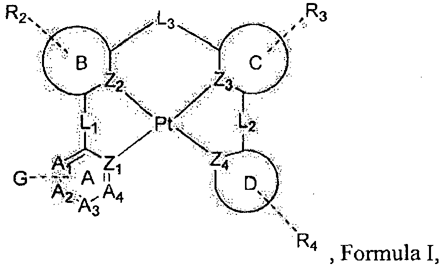 is provided, wherein G has the structure 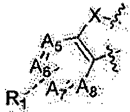 and wherein G is fused to any two adjacent carbon atoms on ring A. Ring B, ring C, and ring D are 5- or 6-membered carbocyclic or heterocyclic aromatic rings. L₁, L₂, and L₃ are independently selected from the group consisting of a single bond, BR, NR, PR, O, S, Se, C=O, S=O, SO₂, CRR', SiRR', and GeRR'. At least one of L₁, L₂, and L₃ is not a single bond, and X is selected from the group consisting of BR, NR, PR, O, S, Se, C=O, S=O, SO₂, CRR', SiRR', and GeRR'. Z₁, Z₂, Z₃, and Z₄ are nitrogen or carbon atoms, and A₁, A₂, A₃, A₄, A₅, A₆, A₇, and A₈ comprise carbon or nitrogen. R₁, R₂, R₃, and R₄ independently represent mono-, di-, tri-, or tetra-substitution, wherein R₁ is optionally fused, R₂ is optionally fused to ring B, R₃ is optionally fused to ring C, and R₄ is optionally fused to ring D. R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one embodiment, the first device is a consumer product. In another embodiment, the first device is an organic light-emitting device. In one embodiment, the first device comprises a lighting panel. In one embodiment, the organic layer is an emissive layer and the compound is an emissive dopant. In another embodiment, the organic layer is an emissive layer and the compound is a non-emissive dopant.

In one embodiment, the organic layer further comprises a host. In another embodiment, the host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CHCₙH₂ₙ₊₁, Ar₁, Ar₁-Ar₂, CₙH₂ₙ-Ar₁, or no substitution, wherein Ar₁ and Ar₂ are independently selected from the group consisting of benzene, biphenyl, naphthalene, triphenylene, carbazole, and heteroaromatic analogs thereof, and n is from 1 to 10.

In one embodiment, the host has the formula

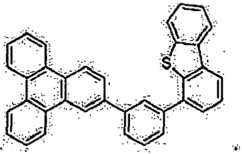

In another embodiment, the host is selected from the group consisting of 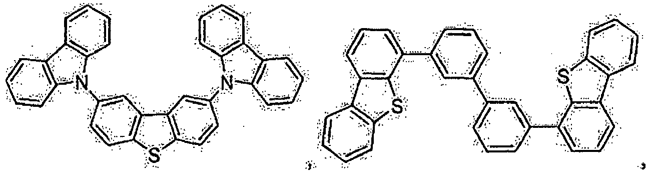 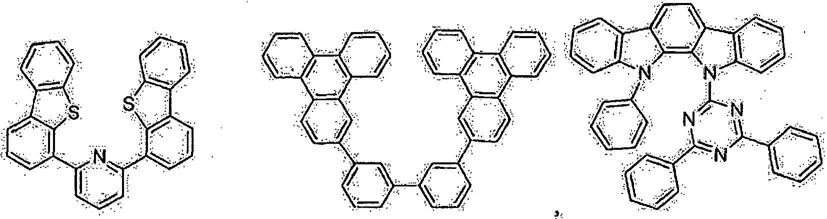 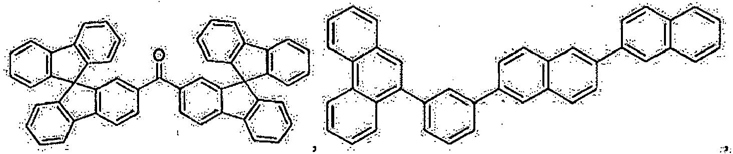 and combinations thereof.

In one embodiment, the host is a metal complex.

### BRIEF DESCRIPTION OF THE DRAWINGS

FIG. 1 shows an organic light emitting device.
FIG. 2 shows an inverted organic light emitting device that does not have a separate electron transport layer.

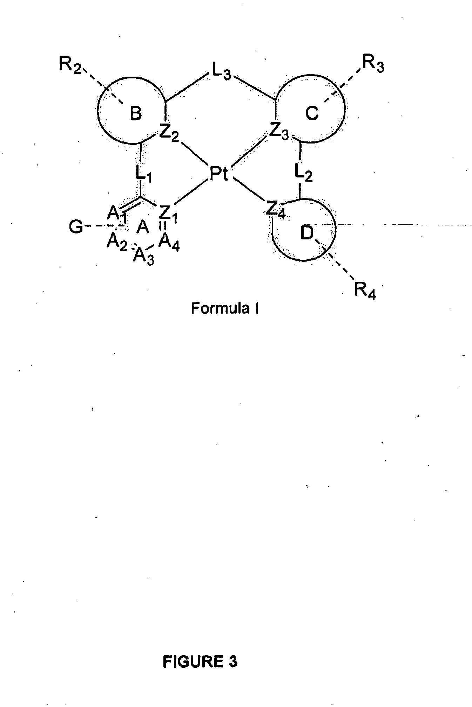

FIG. 3 shows a compound of Formula I.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

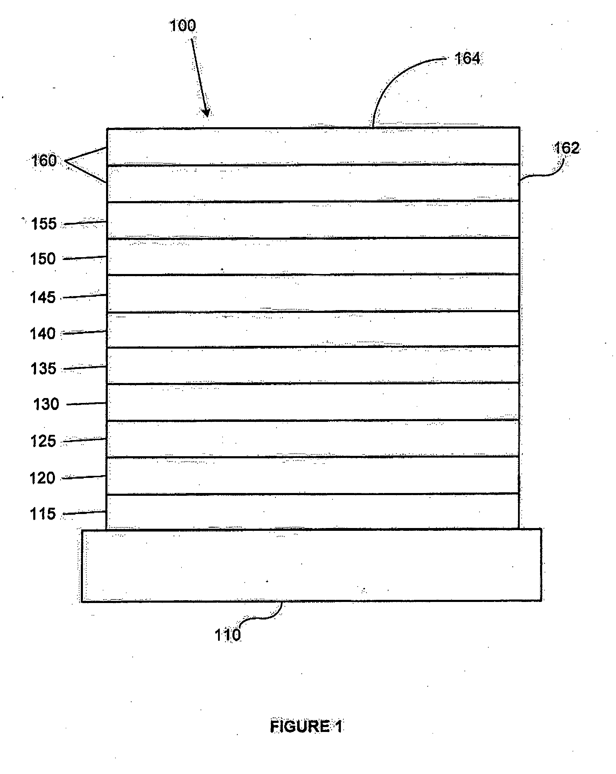

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, and a cathode 160. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F.sub.4-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

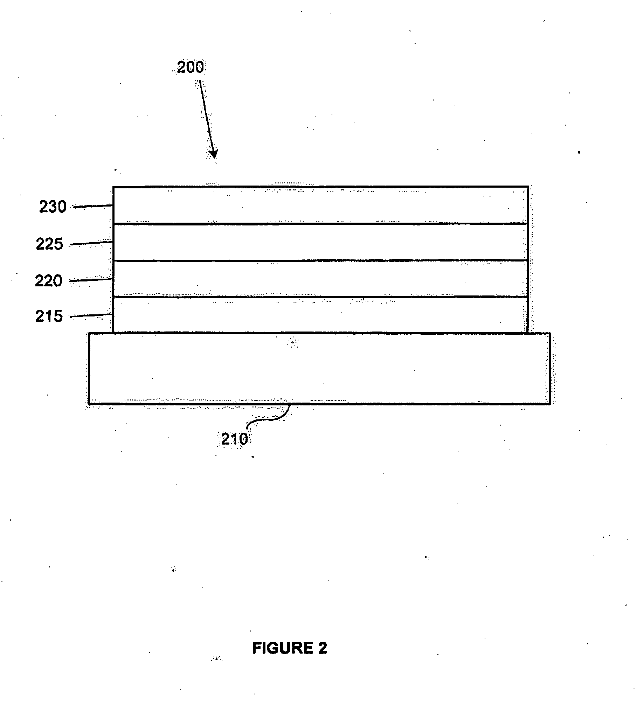

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al, , and deposition by organic vapor jet printing (OVJP), such as described in U.S. patent application Ser. No. 10/233,470. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the invention may be incorporated into a wide variety of consumer products, including flat panel displays, computer monitors, televisions, billboards, lights for interior or exterior illumination and/or signaling, heads up displays, fully transparent displays, flexible displays, laser printers, telephones, cell phones, personal digital assistants (PDAs), laptop computers, digital cameras, camcorders, viewfinders, micro-displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C.).

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The terms halo, halogen, alkyl, cycloalkyl, alkenyl, alkynyl, arylkyl, heterocyclic group, aryl, aromatic group, and heteroaryl are known to the art, and are defined in US 7,279,704 at cols. 31-32, which are incorporated herein by reference.

A compound having the formula: 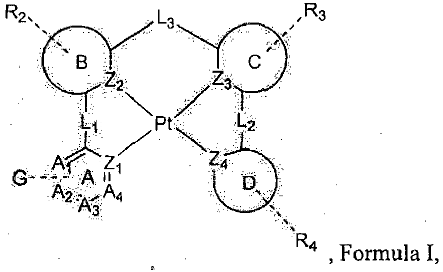 is provided, wherein G has the structure 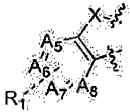 and wherein G is fused to any two adjacent carbon atoms on ring A. Ring B, ring C, and ring D are 5- or 6-membered carbocyclic or heterocyclic aromatic rings. L₁, L₂, and L₃ are independently selected from the group consisting of a single bond, BR, NR, PR, O, S, Se, C=O, S=O, SO₂, CRR', SiRR', and GeRR'. At least one of L₁, L₂, and L₃ is not a single bond, and X is selected from the group consisting of BR, NR, PR, O, S, Se, C=O, S=O, SO₂, CRR', SiRR', and GeRR'. Z₁, Z₂, Z₃, and Z₄ are nitrogen or carbon atoms, and A₁, A₂, A₃, A₄, A₅, A₆, A₇, and A₈ comprise carbon or nitrogen. R₁, R₂, R₃, and R₄ independently represent mono-, di-, tri-, or tetra-substitution, wherein R₁ is optionally fused, R₂ is optionally fused to ring B, R₃ is optionally fused to ring C, and R₄ is optionally fused to ring D. R₃ and R₄ are optionally linked to form a ring. If L₂ is not a single bond, R₃ and L₂ or R₄ and L₂ are optionally linked to form a ring. R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one embodiment, the compound has a neutral charge. In one embodiment, the the platinum center in the compounds of Formula I is platinum (II). In one embodiment, at least two of Z₁, Z₂, Z₃, and Z₄ are nitrogen atoms. In another embodiment, at least two of Z₁, Z₂, Z₃, and Z₄ are carbon atoms.

In one embodiment, at least one of ring B, ring C, and ring D comprises a carbene ligand coordinated to Pt. In another embodiment, at least one of Z₁, A₁, A₂, A₃, A₄, A₅, A₆, A₇, and A₈ is a nitrogen atom.

In one embodiment, the compound has the formula: 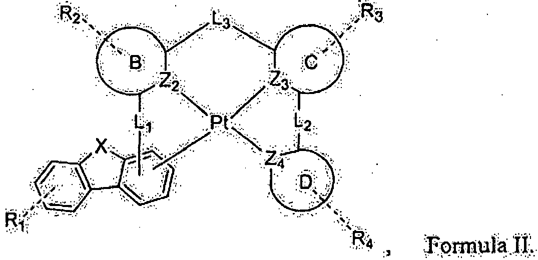 In the compound of Formula II, L₁ and the bond to the platinum atom can be on any two adjacent atom centers on the illustrated dibenzo ring system.

In another embodiment, the compound has the formula;

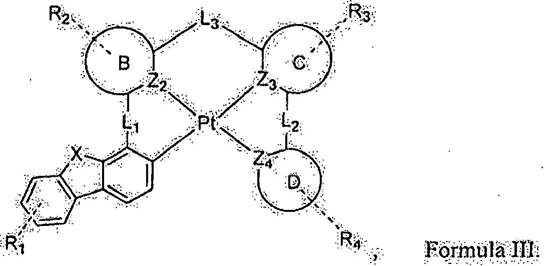

In one embodiment, the compound has the formula 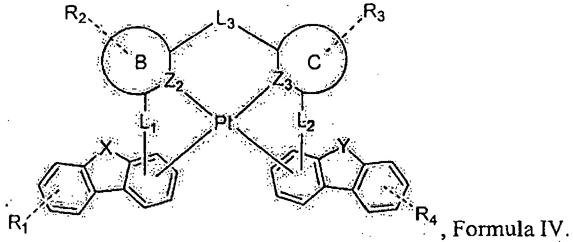 In the compound of Formula IV, L₁ and the bond to the platinum atom can be on any two adjacent atom centers on the illustrated dibenzo ring system (i.e. ring system bearing the X fragment, which is also referred to herein as DBX). Similarly, L₂ and the bond to the platinum atom can be on any two adjacent atom centers on the illustrated dibenzo ring system (i.e. ring system bearing the Y fragment, which is also referred to herein as DBY). Y is selected from the group consisting of BR, NR, PR, O, S, Se, C=O, S=O, SO₂, CRR', SiRR', and GeRR'.

In another embodiment, the compound has the formula:

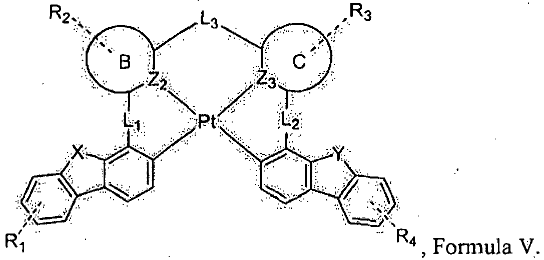

In one embodiment, L₁ and L₂ are single bonds. In another embodiment, L₃ is independently selected from the group consisting of O, S, and NR. In another embodiment, L₃ is NR, and R is phenyl or substituted phenyl. In one embodiment, L₃ is O.

In one embodiment, Z₂ and Z₃ are nitrogen atoms. In another embodiment, Z₂ and Z₄ are nitrogen atoms. In one embodiment, X is independently selected from the group consisting of O, S, and NR. In one embodiment, X is O.

In one embodiment, the compound is selected from the group consisting of: 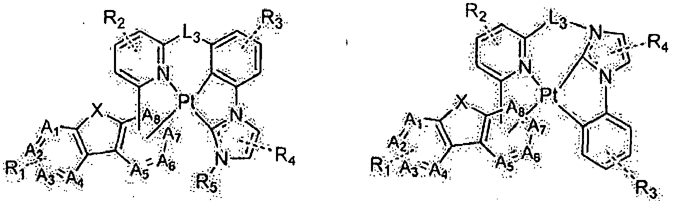 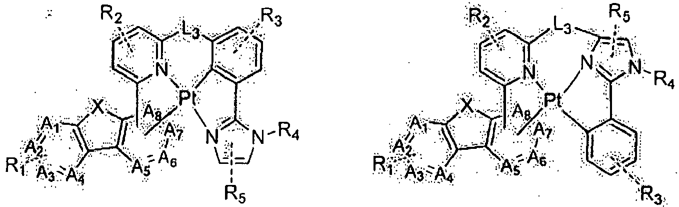 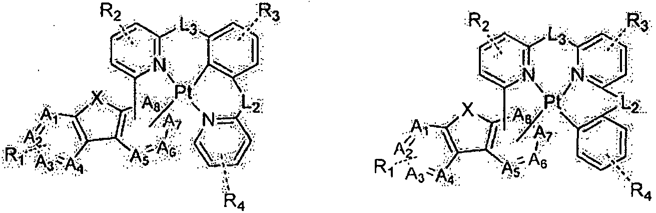 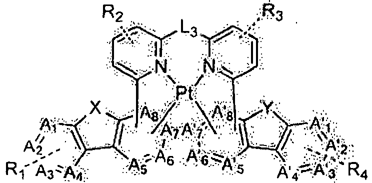 wherein Y is selected from the group consisting of BR, NR, PR, O, S, Se, C=O, S=O, SO₂, CRR', SiRR', and GeRR'. A₁', A₂', A₃', A₄', A₅', A₆', A₇', and A₈' comprise carbon or nitrogen. At most one of A₁, A₂, A₃, A₄ is nitrogen, and at most one of A₁', A₂', A₃', A₄' is nitrogen. At most one of A₅, A₆, A₇, Ag is nitrogen, and the nitrogen is not bound to Pt. At most one of A₅', A₆', A₇', A₈' is nitrogen, and the nitrogen is not bound to Pt. The Pt forms at least two Pt-C bonds and R₃ and R₄ may be fused together to form a ring. R₅ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one embodiment, the compounds of Formula I include:

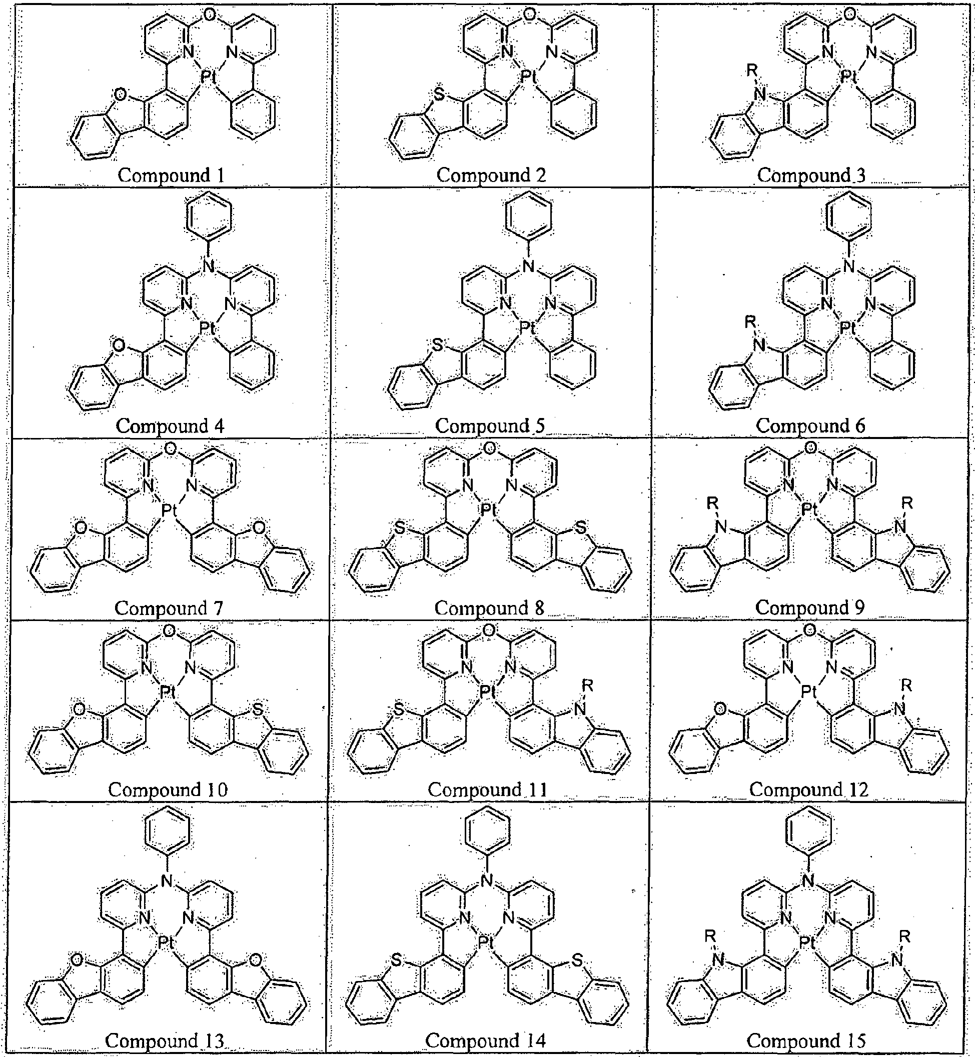

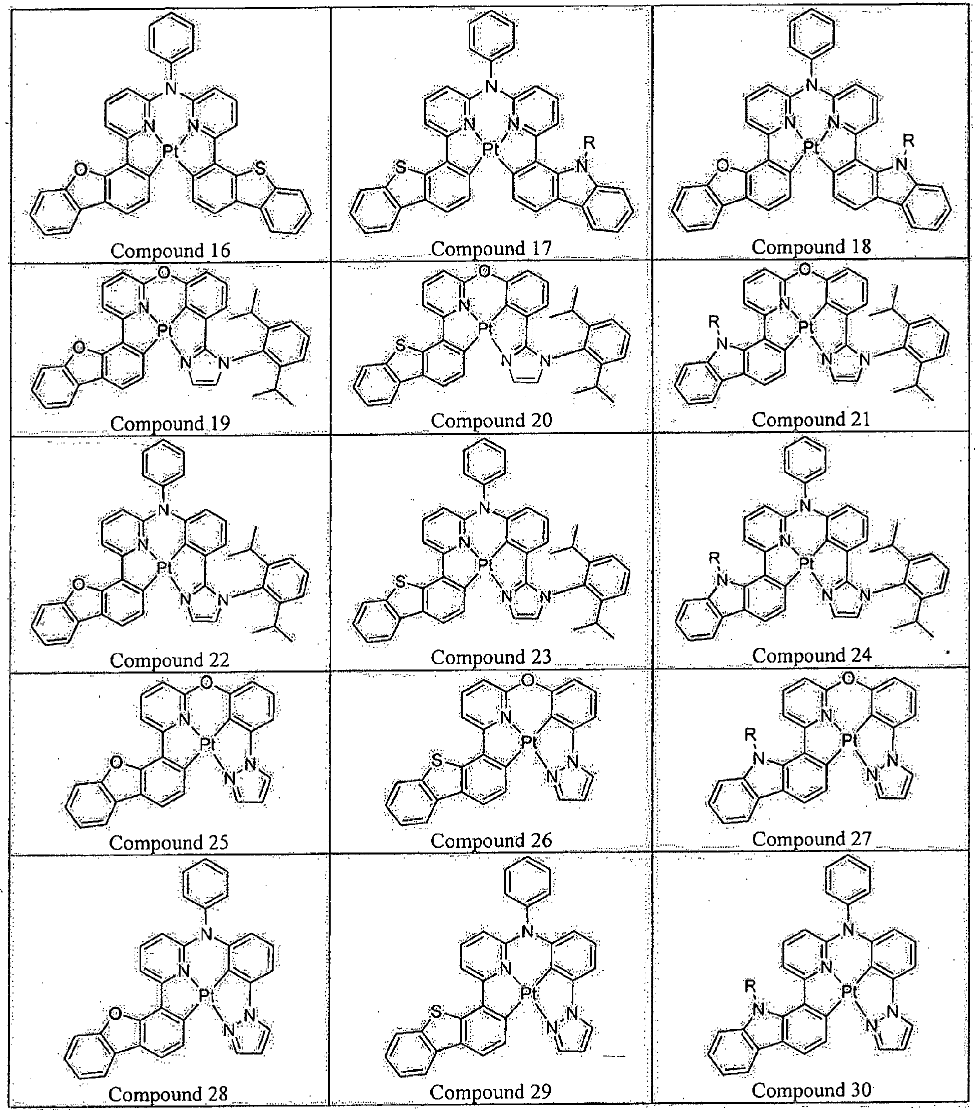

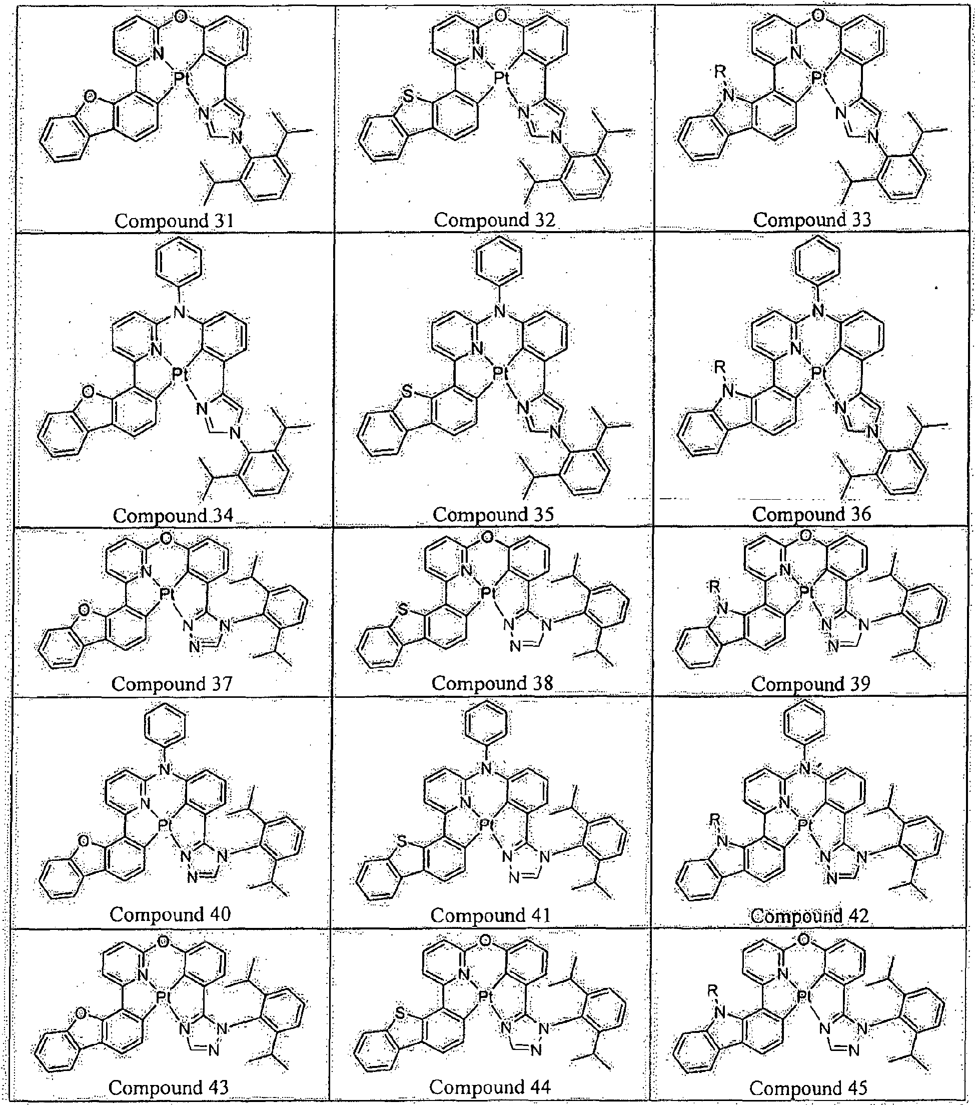

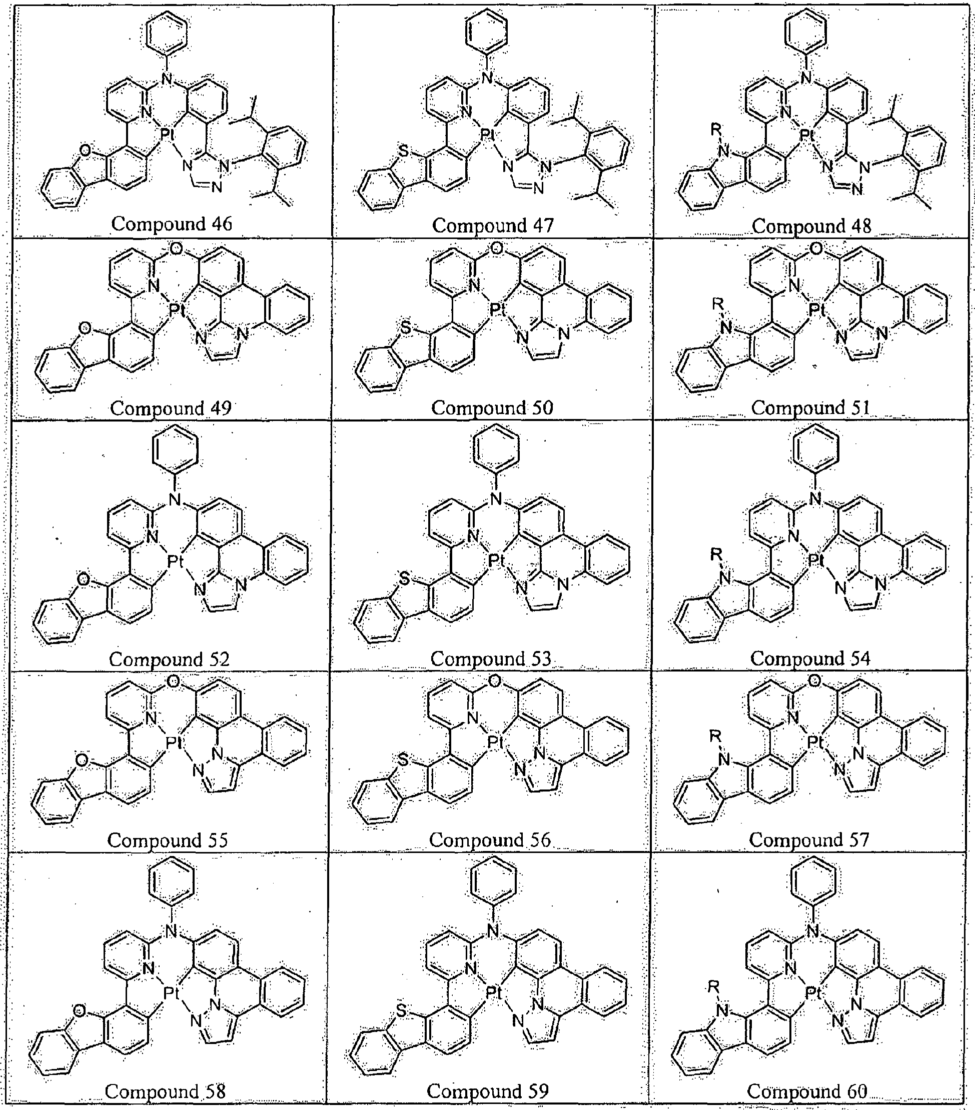

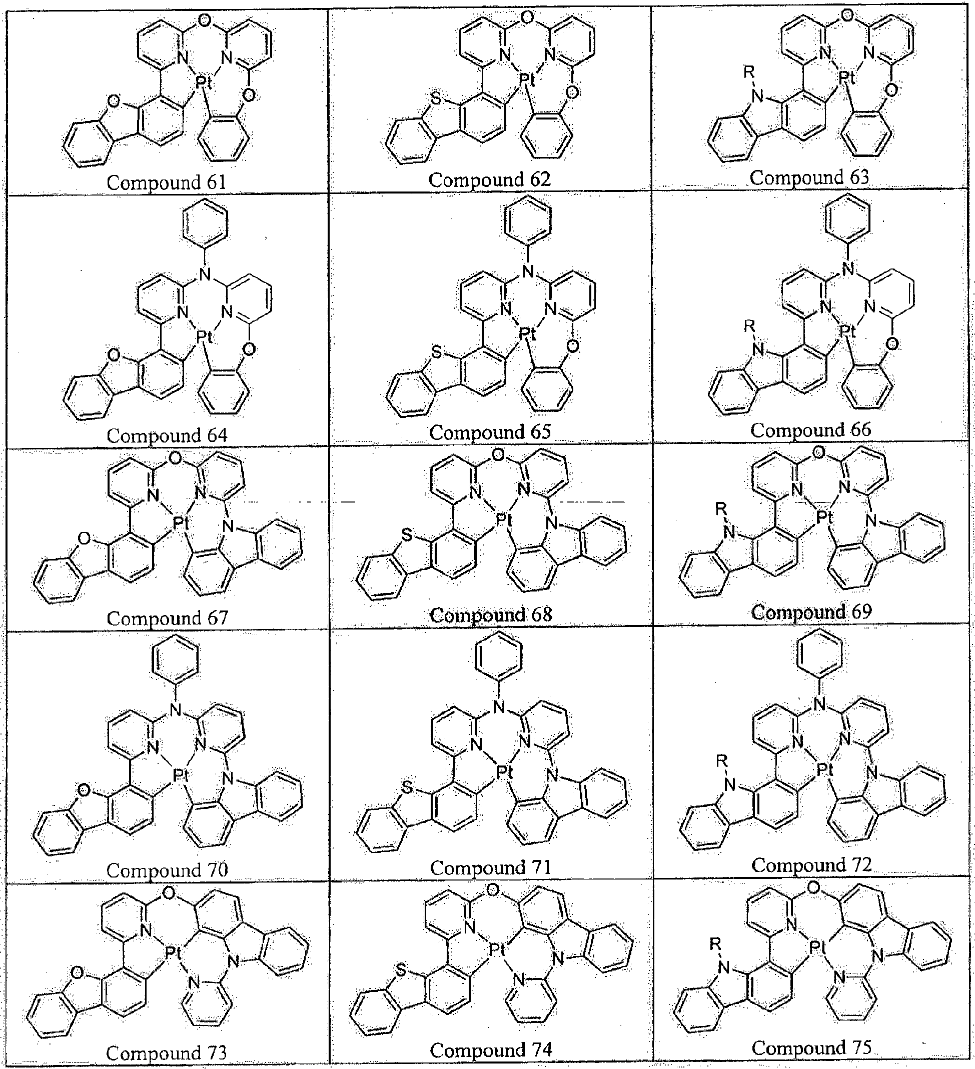

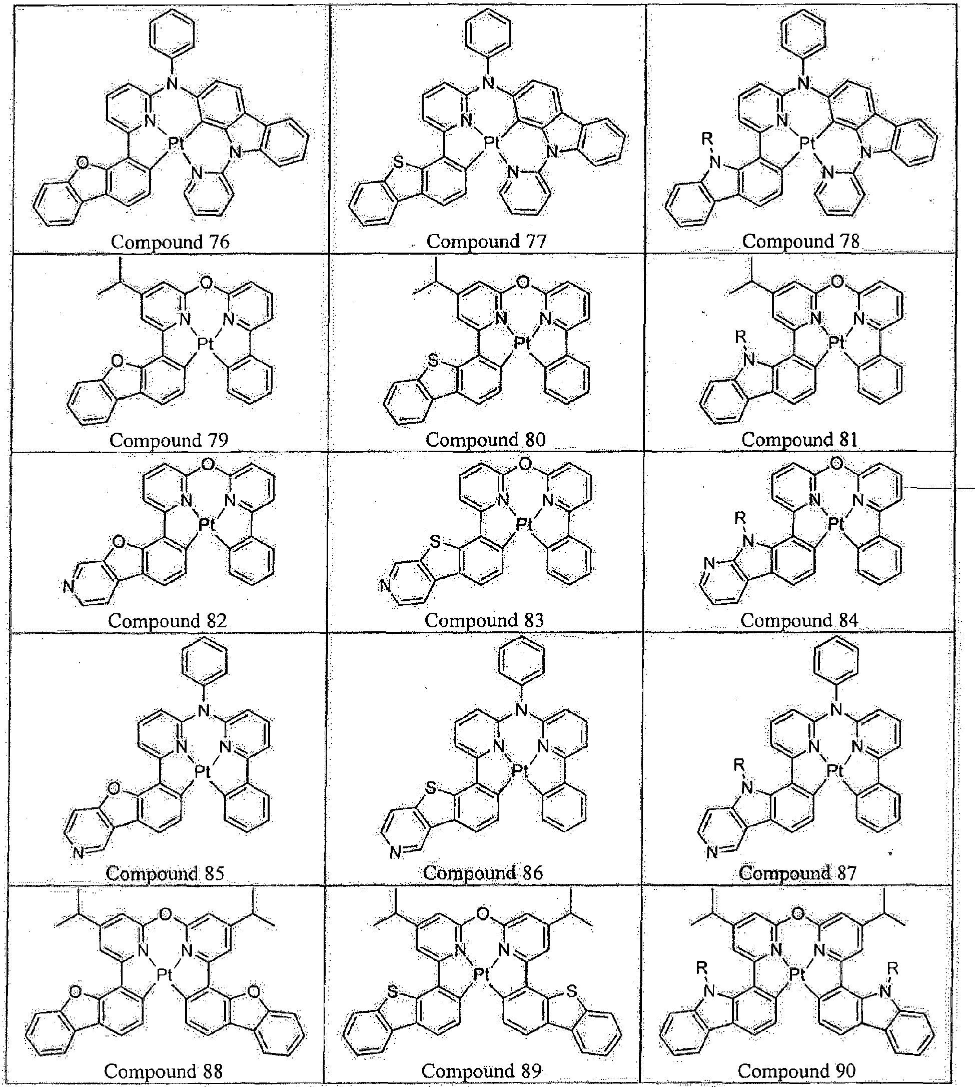

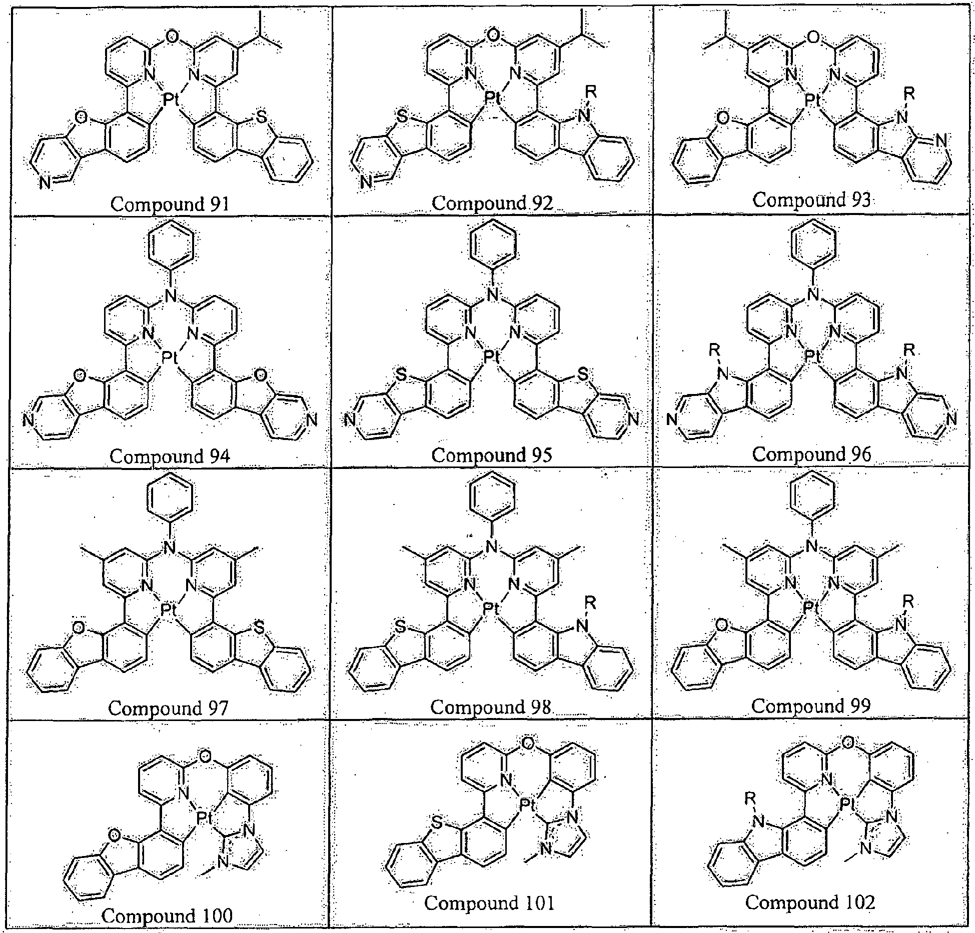

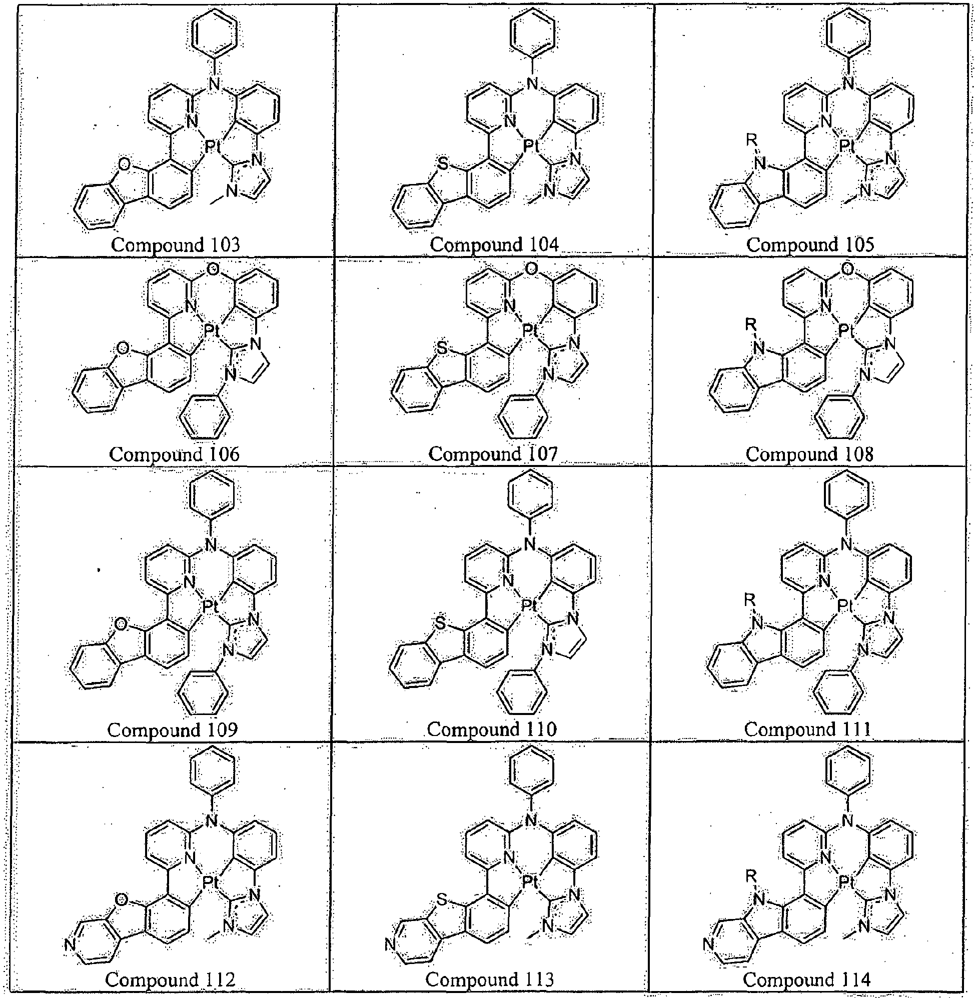

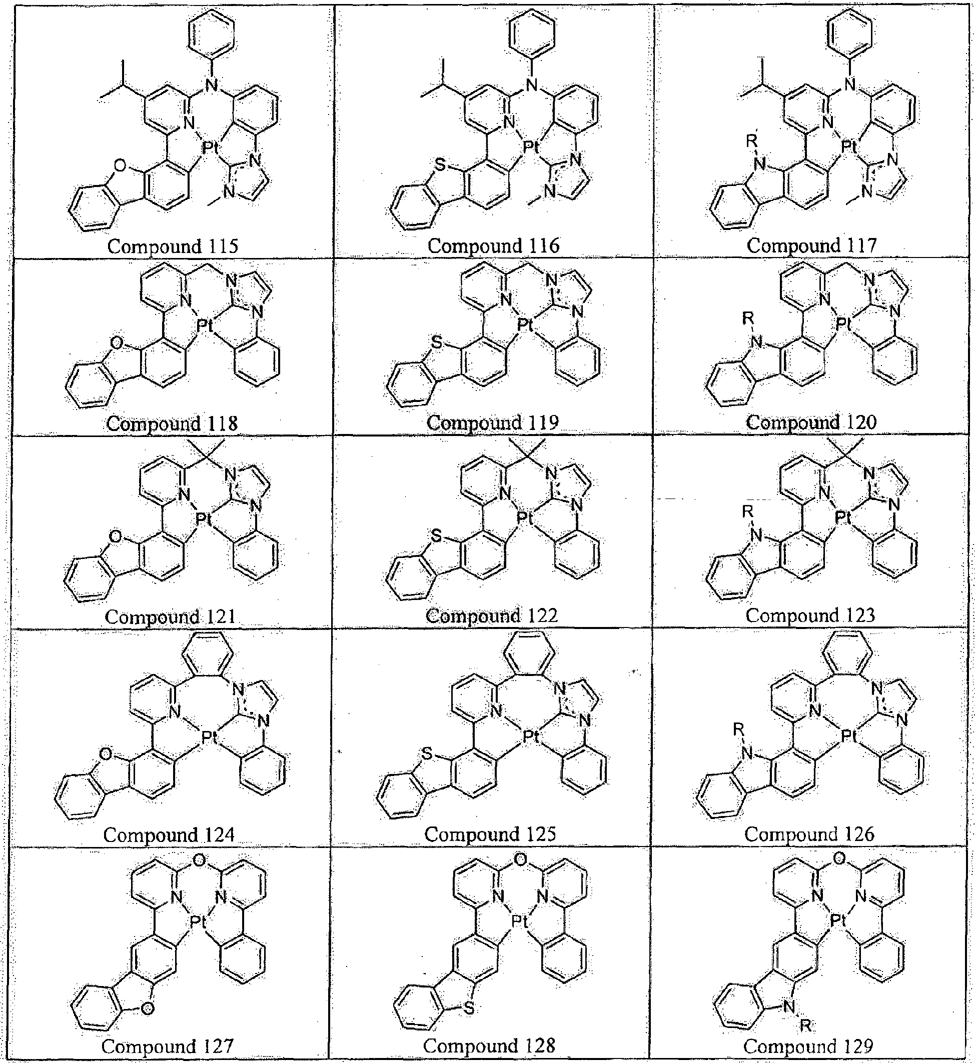

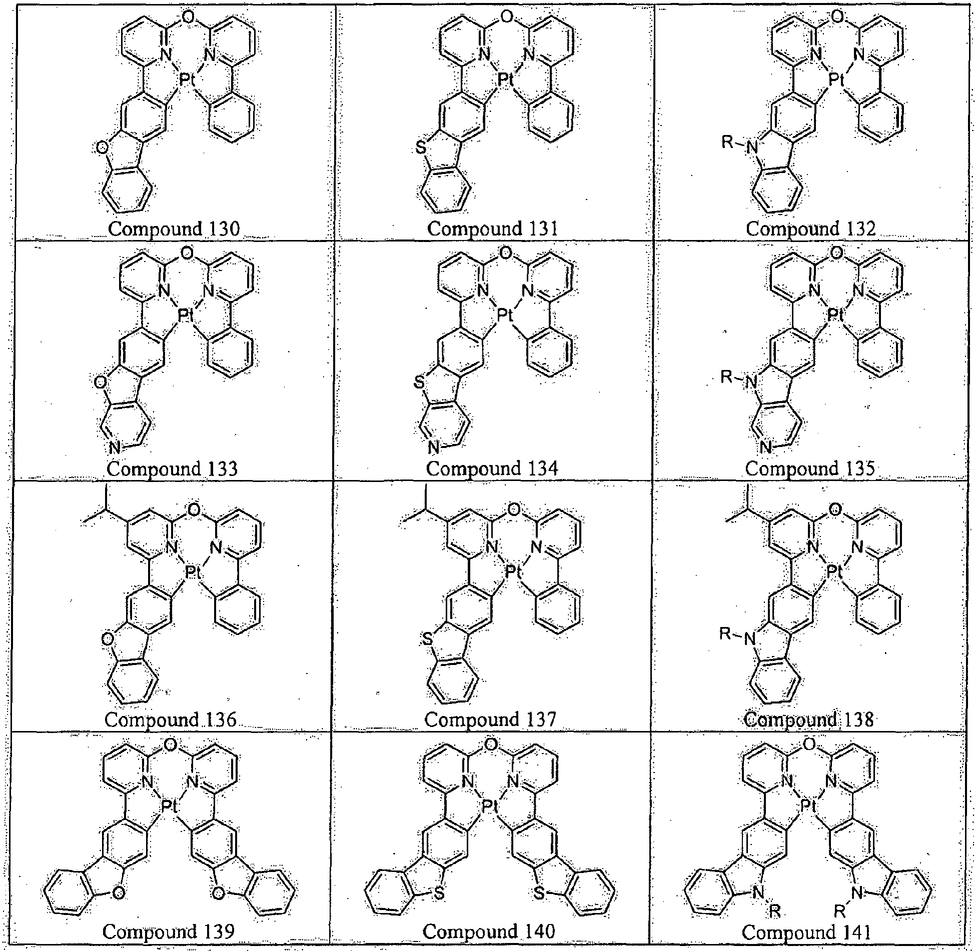

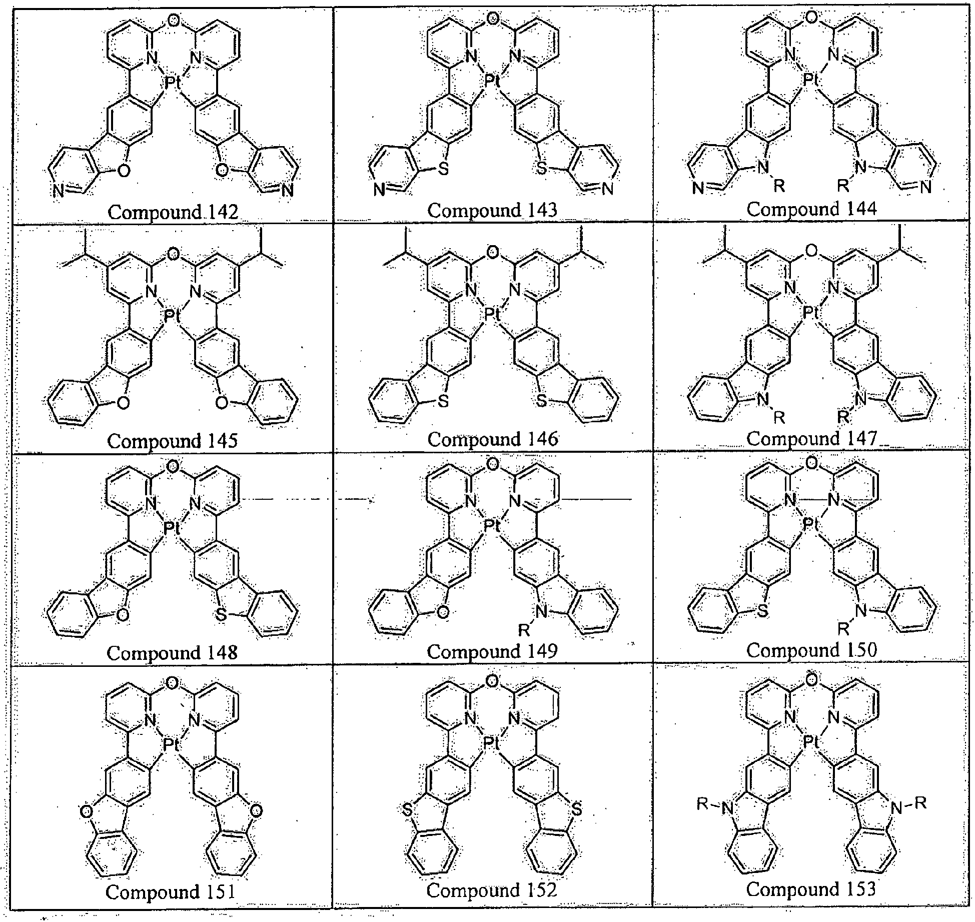

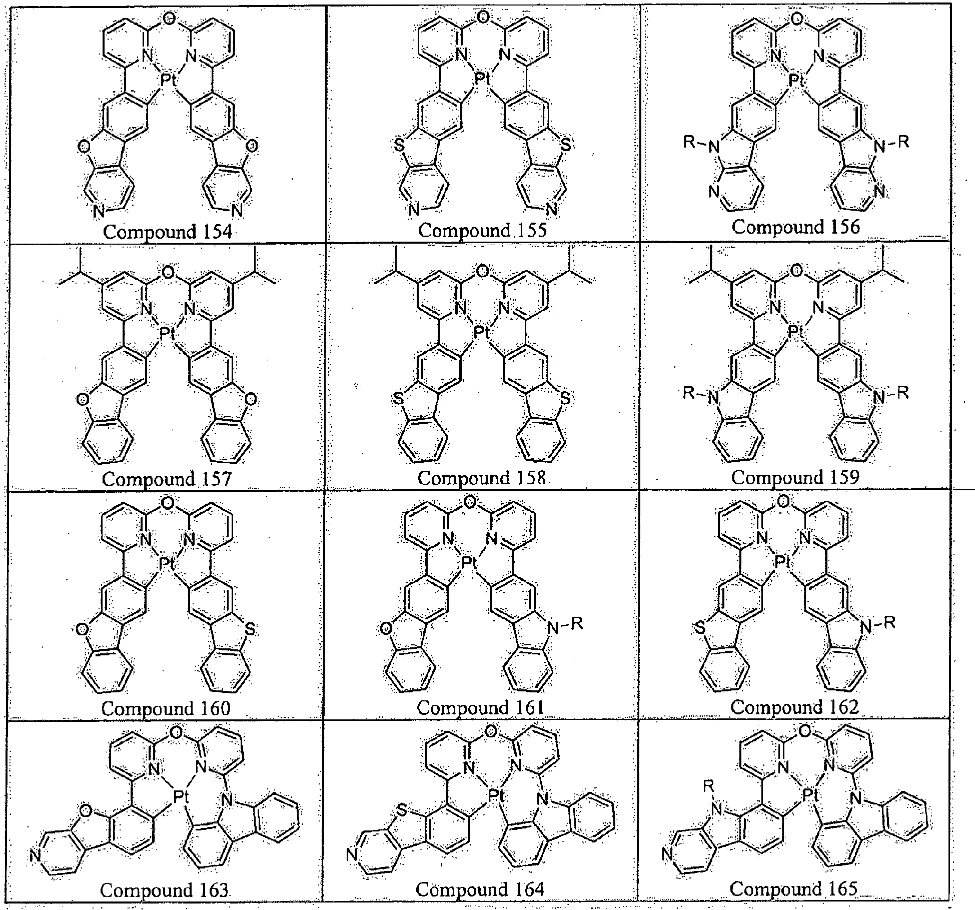

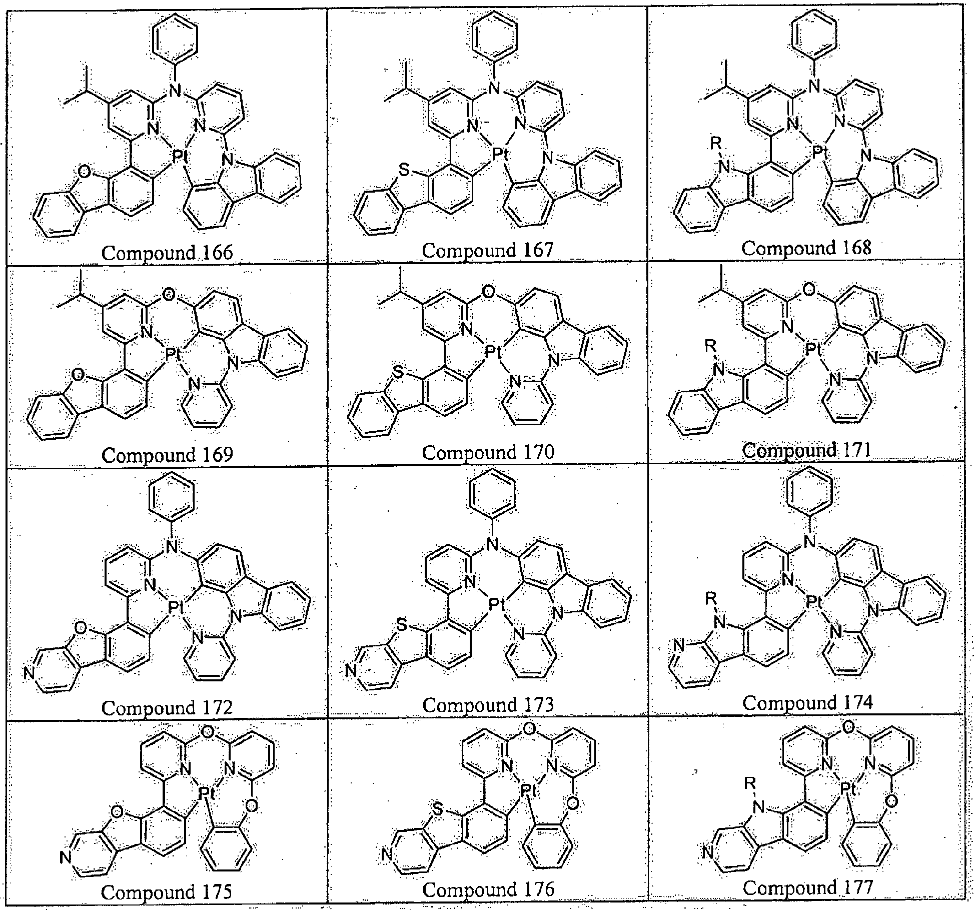

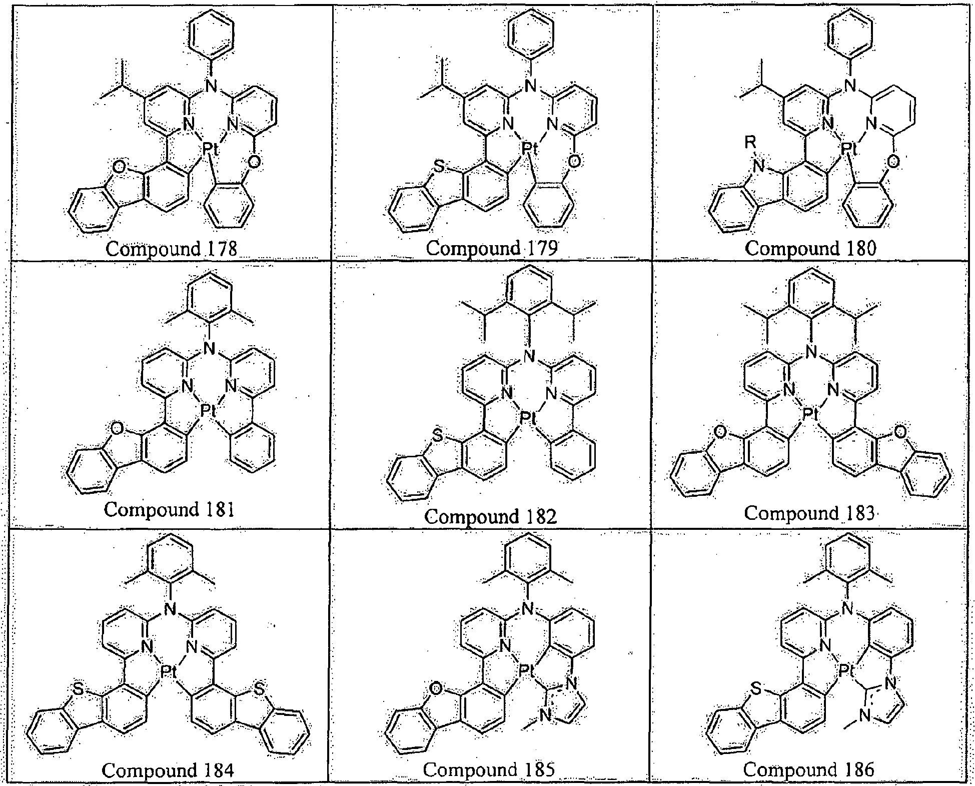

In Compounds 1-186, when R is present it can be hydrogen, deuterium, halide, alkyl, cycloalkyl, heteroalkyl, arylalkyl, aryl, heteroaryl, acyl and combinations thereof.

A first device is provided. The first device comprises a first organic light emitting device, further comprising an anode, a cathode, and an organic layer, disposed between the anode and the cathode, comprising a compound having the formula: 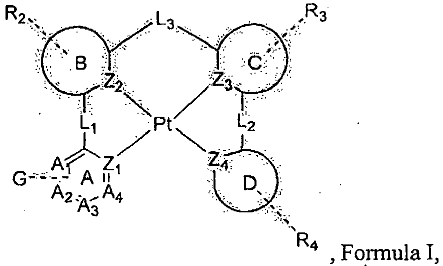 is provided, wherein G has the structure 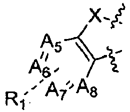 and wherein G is fused to any two adjacent carbon atoms on ring A. Ring B, ring C, and ring D are 5- or 6-membered carbocyclic or heterocyclic aromatic rings. L₁, L₂, and L₃ are independently selected from the group consisting of a single bond, BR, NR, PR, O, S, Se, C=O, S=O, SO₂, CRR', SiRR', and GeRR'. At least one of L₁, L₂, and L₃ is not a single bond, and X is selected from the group consisting of BR, NR, PR, O, S, Se, C=O, S=O, SO₂, CRR', SiRR', and GeRR'. Z₁, Z₂, Z₃, and Z₄ are nitrogen or carbon atoms, and A₁, A₂, A₃, A₄, A₅, A₆, A₇, and A₈ comprise carbon or nitrogen. R₁, R₂, R₃, and R₄ independently represent mono-, di-, tri-, or tetra-substitution, wherein R₁ is optionally fused, R₂ is optionally fused to ring B, R₃ is optionally fused to ring C, and R₄ is optionally fused to ring D. R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one embodiment, the first device is a consumer product. In another embodiment, the first device is an organic light-emitting device. In one embodiment, the first device comprises a lighting panel. In one embodiment, the organic layer is an emissive layer and the compound is an emissive dopant. In another embodiment, the organic layer is an emissive layer and the compound is a non-emissive dopant.

In one embodiment, the organic layer further comprises a host. In another embodiment, the host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CHCₙH₂ₙ₊₁, Ar₁, Ar₁-Ar₂, CₙH₂ₙ-Ar₁, or no substitution, wherein Ar₁ and Ar₂ are independently selected from the group consisting of benzene, biphenyl, naphthalene, triphenylene, carbazole, and heteroaromatic analogs thereof, and n is from 1 to 10.

In one embodiment, the host has the formula

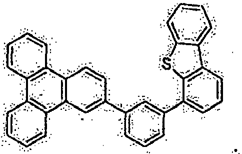

In another embodiment, the host is selected from the group consisting of 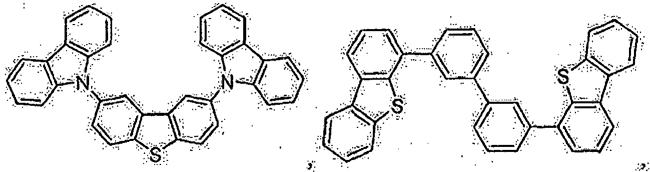 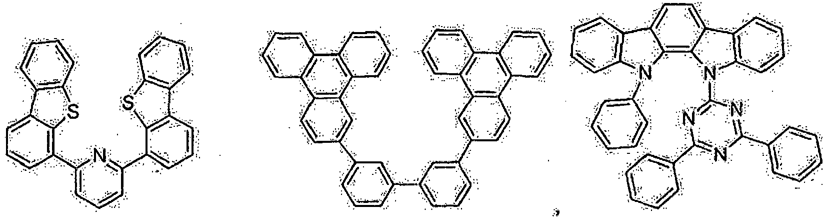 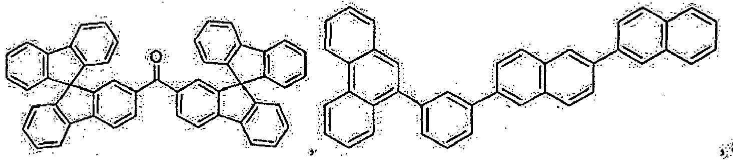 and combinations thereof.

In one embodiment, the host is a metal complex.

### Device Examples

All device examples were fabricated by high vacuum (<10⁻⁷ Torr (1.33x10⁻⁵ Pa)) thermal evaporation (VTE). The anode electrode is 1200Å of indium tin oxide (ITO). The cathode consisted of 10 Å of LiF followed by 1000 Å of A1. All devices were encapsulated with a glass lid sealed with an epoxy resin in a nitrogen glove box (<1 ppm of H₂O and O₂) immediately after fabrication, and a moisture getter was incorporated inside the package.

The organic stack of the devices consisted of sequentially, from the ITO surface, 100 Å of Compound A as the hole injection layer (HIL), 300 Å of 4,4'-bis[N-(1-naphthyl)-N-phenylamino]biphenyl (a-NPD) as the hole transporting later (HTL), 300 Å of Compound B doped with Compound 4 as the emissive layer (EML), 50 Å of Compound B as BL, and 450 Å of Alq as the ETL. Comparative Device Examples were fabricated in a manner similar to that of the Device Examples, except that Compound X was used as the emitter instead of Compound 4. The device results and data are summarized in Tables I and 2 from those devices. As used herein, Compound A, Compound B, Alq, α-NPD, and Compound X have the following structures:

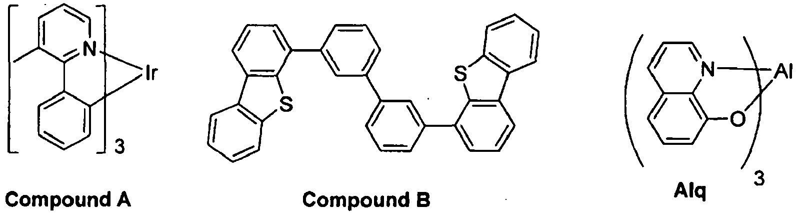

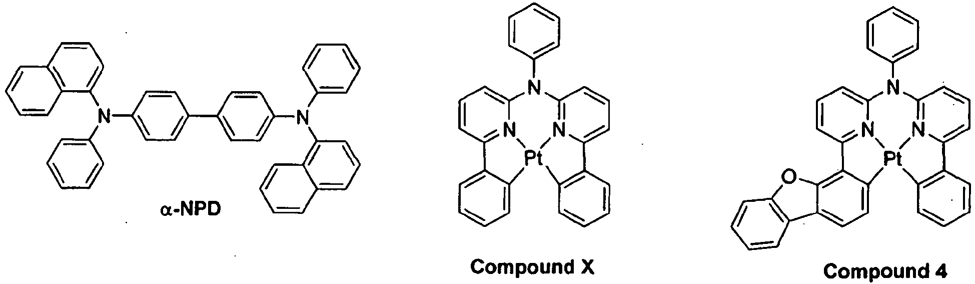

**TABLE 1. VTE Phosphorescent OLEDs**

| **Example** | **HIL** | **HTL** | **EML (doping %)** | | **BL** | **ETL** |
|---|---|---|---|---|---|---|
| Example 1 | Compound A | NPD | Compound B | Compound 4 20% | Compound B | Alq |
| Comparative Example 1 | Compound A | NPD | Compound B | Compound X 15% | Compound B | Alq |

**TABLE 2. VTE Device Data**

| **Example** | **1931 CIE** | | | | **At 1000 nits** | | | | **At 40 mA/cm²** | |
|---|---|---|---|---|---|---|---|---|---|---|
| | **x** | **y** | **λₘₐₓ** | **FWHM (nm)** | **Voltage (V)** | **LE (Cd/A)** | **EQE (%)** | **PE (Im/W)** | **L₀ (nits)** | **LT80% (h)** |
| Example 1 | 0.422 | 0.552 | 538 | 64 | 8.4 | 10.6 | 4.0 | 4.0 | 2001 | 145 |
| Comparative Example 1 | 0.357 | 0.581 | 514 | 60 | 9.7 | 8.2 | 2.8 | 2.7 | 2989 | 58 |

OLED devices incorporating compounds of Formula I have demonstrated superior properties. As a merely illustrative example, Example 1, which incorporates Compound 4 containing a dibenzofuran moiety, has a higher efficiency (10.6 Cd/A, 4.0% EQE, 4.0 lm/W) than the Comparative Example, which uses Compound X, lacking any dibenzo (DBX) fragment (9.7 Cd/A, 2.8% EQE, 2.7 lm/W). Devices incorporating Compound 4 also demonstrated a longer lifetime (145 h) in comparison to Compound X (58 h) and a lower turn-on voltage (8.4 V) versus the Comparative Example (9.7 V). These results indicate that incorporating compounds of Formula I, which bear one or more DBX groups, results in devices with highly desirable properties.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### HIL/HTL:

A hole injecting/transporting material to be used in the present invention is not particularly limited, and any compound may be used as long as the compound is typically used as a hole injecting/transporting material. Examples of the material include, but not limit to: a phthalocyanine or porphryin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and sliane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

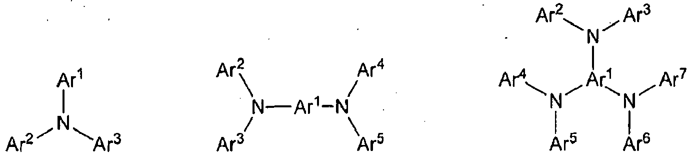

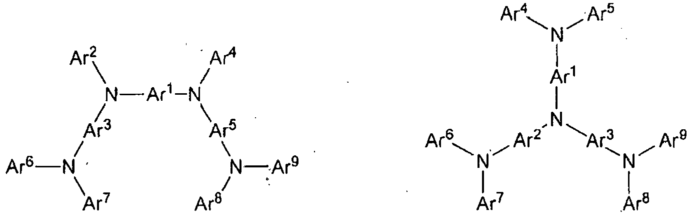

Each of Ar¹ to Ar⁹ is selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each Ar is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one embodiment, Ar¹ to Ar⁹ is independently selected from the group consisting of:

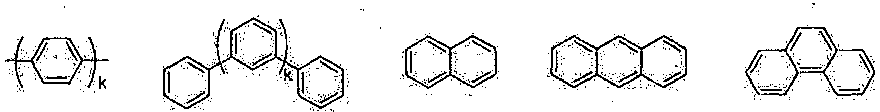

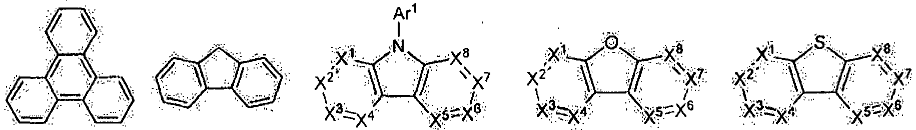

k is an integer from 1 to 20; X¹ to X⁸ is C (including CH) or N; Ar¹ has the same group defined above.

Examples of metal complexes used in HIL or HTL include, but not limit to the following general formula:

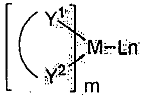

M is a metal, having an atomic weight greater than 40; (Y¹-Y²) is a bidentate ligand, Y¹ and Y² are independently selected from C, N, O, P, and S; L is an ancillary ligand; m is an integer value from 1 to the maximum number of ligands that may be attached to the metal; and m+n is the maximum number of ligands that may be attached to the metal.

In one embodiment, (Y¹-Y²) is a 2-phenylpyridine derivative.

In another embodiment, (Y¹-Y²) is a carbene ligand.

In another embodiment, M is selected from Ir, Pt, Os, and Zn.

In a further embodiment, the metal complex has a smallest oxidation potential in solution vs. Fc⁺/Fc couple less than about 0.6 V.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant.

Examples of metal complexes used as host are preferred to have the following general formula:

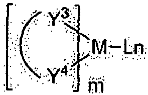

M is a metal; (Y³-Y⁴) is a bidentate ligand, Y³ and Y⁴ are independently selected from C, N, O, P, and S; L is an ancillary ligand; m is an integer value from 1 to the maximum number of ligands that may be attached to the metal; and m+n is the maximum number of ligands that may be attached to the metal.

In one embodiment, the metal complexes are:

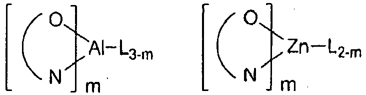

(O-N) is a bidentate ligand, having metal coordinated to atoms O and N.

In another embodiment, M is selected from Ir and Pt.

In a further embodiment, (Y³-Y⁴) is a carbene ligand.

Examples of organic compounds used as host are selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, bcnzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atome, sulfur atom, silicon atom, phosphorus atom, boron atom, chain structural unit and the aliphatic cyclic group. Wherein each group is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one embodiment, host compound contains at least one of the following groups in the molecule:

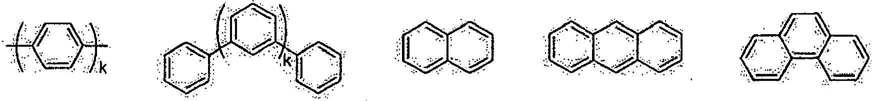

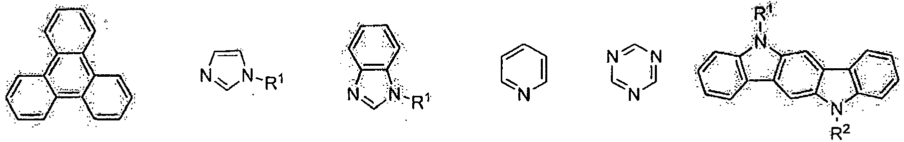

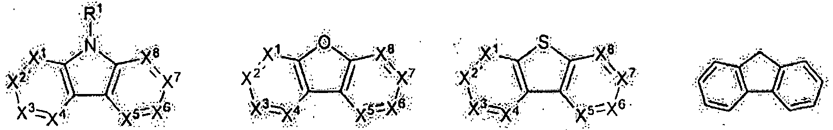

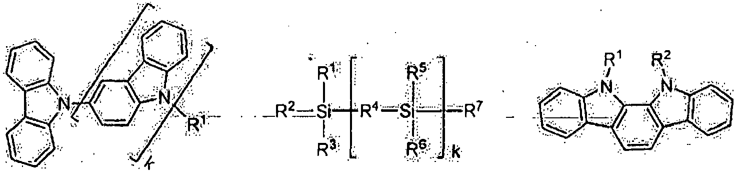

R¹ to R⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above.

k is an integer from 0 to 20.

X¹ to X⁸ is selected from C (including CH) or N.

### HBL:

A hole blocking layer (HBL) may be used to reduce the number of holes and/or excitons that leave the emissive layer. The presence of such a blocking layer in a device may result in substantially higher efficiencies as compared to a similar device lacking a blocking layer. Also, a blocking layer may be used to confine emission to a desired region of an OLED.

In one embodiment, compound used in HBL contains the same molecule used as host described above.

In another embodiment, compound used in HBL contains at least one of the following groups in the molecule:

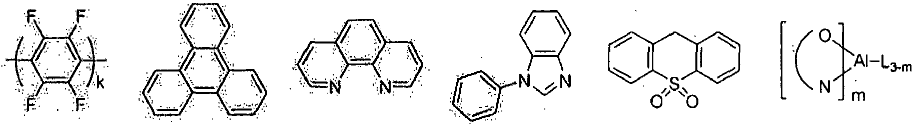

k is an integer from 0 to 20; L is an ancillary ligand, m is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one embodiment, compound used in ETL contains at least one of the following groups in the molecule:

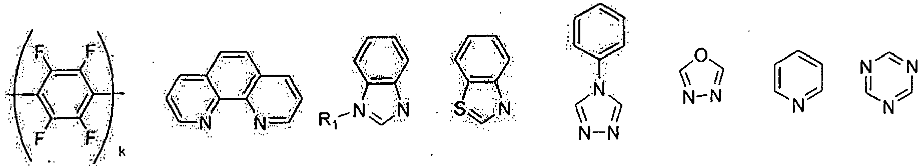

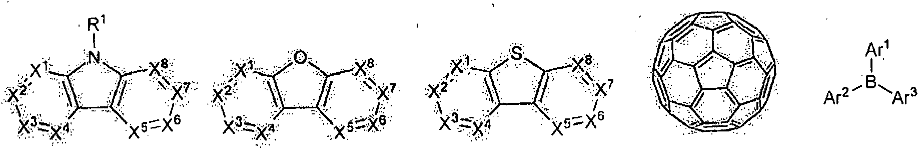

R¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above.

Ar¹ to Ar³ has the similar definition as Ar's mentioned above.

k is an integer from 0 to 20.

X¹ to X⁸ is selected from C (including CH) or N.

In another embodiment, the metal complexes used in ETL contains, but not limit to the following general formula:

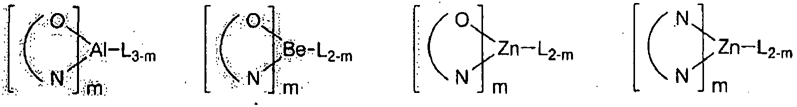

(O-N) or (N-N) is a bidentate ligand, having metal coordinated to atoms O, N or N, N; L is an ancillary ligand; m is an integer value from 1 to the maximum number of ligands that may be attached to the metal.

In any above-mentioned compounds used in each layer of the OLED device, the hydrogen atoms can be partially or fully deuterated.

In addition to and / or in combination with the materials disclosed herein, many hole injection materials, hole transporting materials, host materials, dopant materials, exiton/hole blocking layer materials, electron transporting and electron injecting materials may be used in an OLED. Non-limiting examples of the materials that may be used in an OLED in combination with materials disclosed herein are listed in Table 4 below. Table 4 lists non-limiting classes of materials, non-limiting examples of compounds for each class, and references that disclose the materials.

**TABLE 4**

| **MATERIAL** | **EXAMPLES OF MATERIAL** | **PUBLICATIONS** |
|---|---|---|
| **Hote injection materials** | | |
| Phthalocyanine and porphryin compounds | 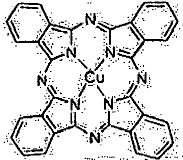 | Appl. Phys. Lett. 69, 2160(1996) |
| Starburst triarylamines | 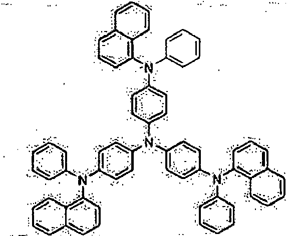 | J. Lumin. 72-74, 985 (1997) |
| CFₓ Fluorohydrocarbon polymer | 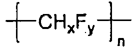 | Appl. Phys. Lett. 78, 673 (2001) |
| Conducting polymers (e.g., PEDOT:PSS, polyaniline, polypthiophene) | 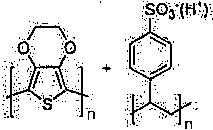 | Synth. Met. 87, 171 (1997) WO2007002683 |
| Phosphonic acid and sliane SAMs | 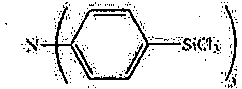 | US20030162053 |
| Triarylamine or polythiophene polymers with conductivity dopants | 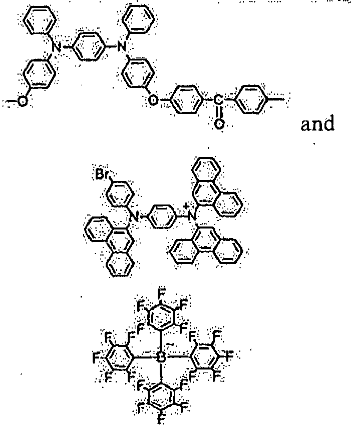 | EP1725079A1 |
| Arylamines complexed with metal oxides such as molybdenum and tungsten oxides | 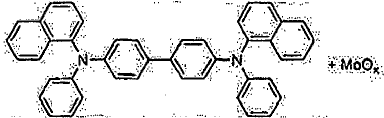 | SID Symposium Digest, 37, 923 (2006) WO2009018009 |
| p-type semiconducting organic complexes | 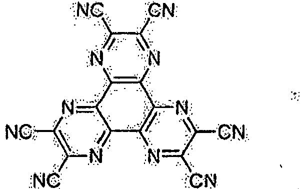 | US20020158242 |
| Metal organometallic complexes | 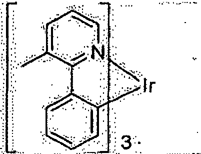 | US20060240279 |
| Cross-linkable compounds | 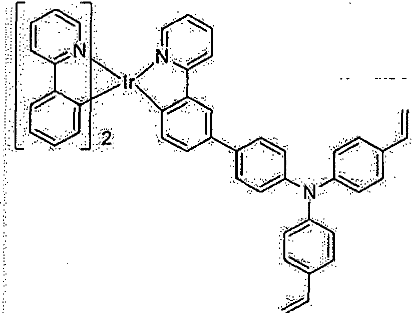 | US20080220265 |

| **Hole transporting materials** | | |
|---|---|---|
| Triarylamines (e.g.,TPD, α-NPD) | 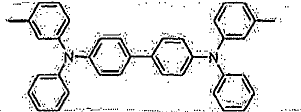 | Appl. Phys. Lett. 51, 913 (1987) |
| | 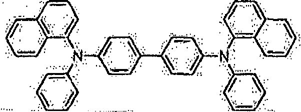 | US5061569 |
| | 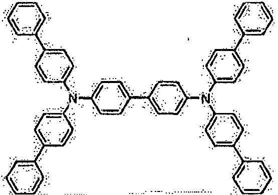 | EP650955 |
| | 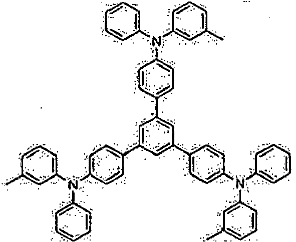 | J. Mater. Chem. 3, 319 (1993) |
| | 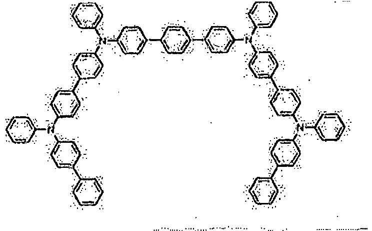 | Appl. Phys. Lett. 90, 183503 (2007) |
| | 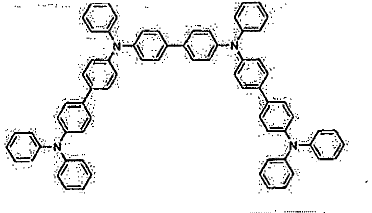 | Appl. Phys. Lett. 90, 183503 (2007) |
| Triaylamine on spirofluorene core | 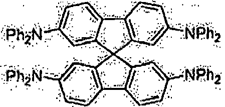 | Synth. Met. 91, 209 (1997) |
| Arylamine carbazole compounds | 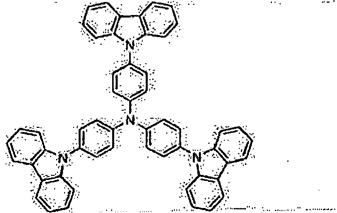 | Adv. Mater. 6, 677 (1994), US20080124572 |
| Triarylamine with (di)benzothiophene/(di)ben zofuran | 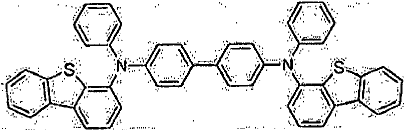 | US20070278938, US20080106190 |
| Indolocarbazoles | 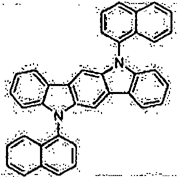 | Synth. Met. 111, 421 (2000) |
| Isoindole compounds | 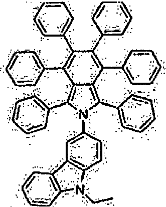 | Chem. Mater. 15, 3148 (2003) |
| Metal carbene complexes | 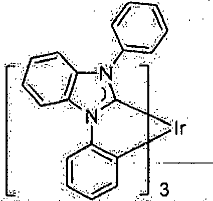 | US20080018221 |

| **Phosphorescent OLED host materials** | | |
|---|---|---|
| **Red hosts** | | |
| Arylcarbazoles | 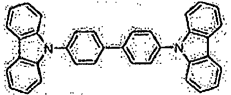 | Appl. Phys. Lett. 78, 1622 (2001) |
| Metal 8-hydroxyquinolates (e.g., Alq₃, BAlq) | 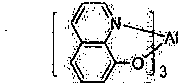 | Nature 395, 151 (1998) |
| | 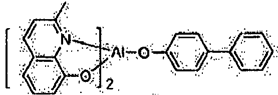 | US20060202194 |
| | 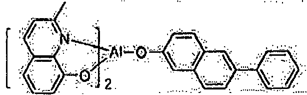 | WO200501451 |
| | 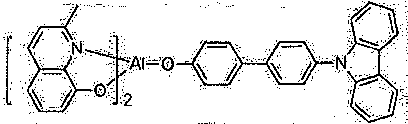 | WO2006072002 |
| Metal phenoxybenzothiazole compounds | 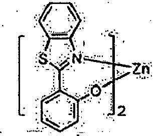 | Appl. Phys. Lett. 90, 123509 (2007) |
| Conjugated oligomers and polymers (e.g., polyfluorene) | 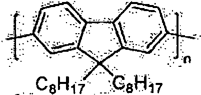 | Org. Electron. 1, 15 (2000) |
| Aromatic fused rings | 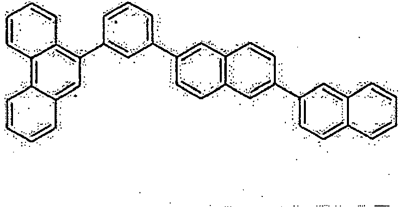 | WO2009066779, WO2009066778, WO2009063833, US20090045731, US20090045730, WO2009008311, US20090008605, US20090009065 |
| Zinc complexes | 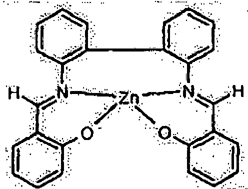 | WO2009062578 |

| **Green hosts** | | |
|---|---|---|
| Arylcarbazoles | 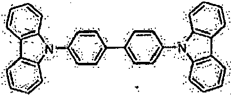 | Appl. Phys. Lett. 78, 1622 (2001) |
| | 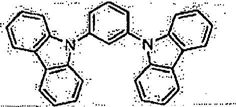 | US20030175553 |
| | 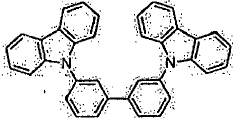 | WO2001039234 |
| Aryltriphenylene compounds | 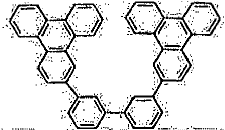 | US20060280965 |
| | 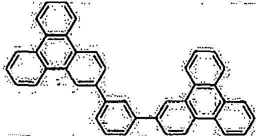 | US20060280965 |
| | 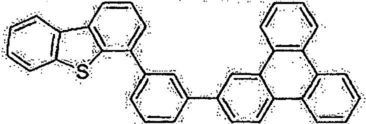 | WO2009021126 |
| Donor acceptor type molecules | 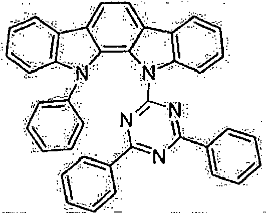 | WO2008056746 |
| Aza-carbazole/DBT/DBF | 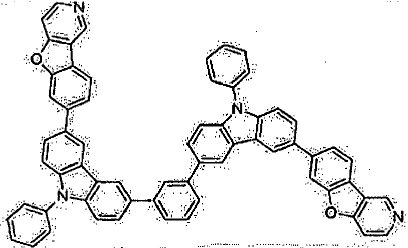 | JP2008074939 |
| Polymers (e.g., PVK) | 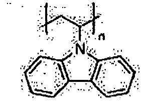 | Appl. Phys. Lett. 77, 2280 (2000) |
| Spirofluorene compounds | 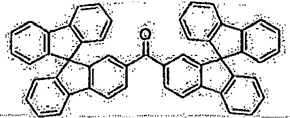 | WO2004093207 |
| Metal phenoxybcnzooxazole compounds | 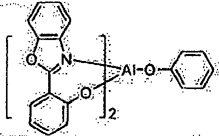 | WO2005089025 |
| | 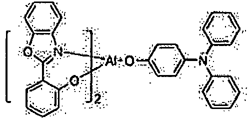 | WO2006132173 |
| | 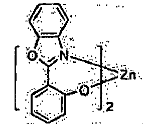 | JP200511610 |
| Spirofluorene-carbazole compounds | 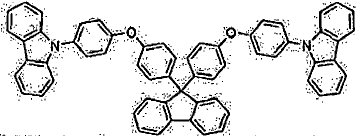 | JP2007254297 |
| | 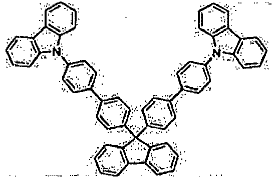 | JP2007254297 |
| Indolocabazoles | 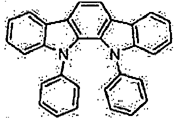 | WO2007063796 |
| | 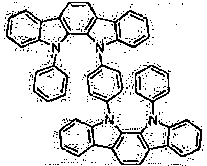 | WO2007063754 |
| 5-member ring electron deficient heterocycles (e.g., triazole, oxadiazole) | 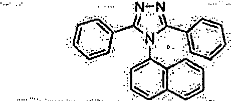 | J. Appl. Phys. 90, 5048 (2001) |
| | 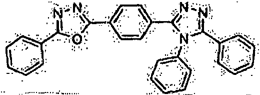 | WO2004107822 |
| Tetraphenylene complexes | 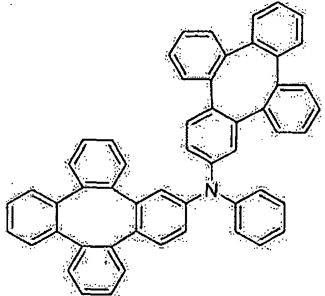 | US20050112407 |
| Metal phenoxypyridine compounds | 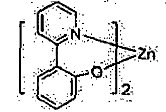 | WO2005030900 |
| Metal coordination complexes (e.g., Zn, A1 with N^N ligands) | 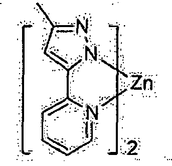 | US20040137268, US20040137267 |

| **Blue hosts** | | |
|---|---|---|
| Arylcarbazoles | 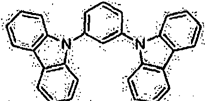 | Appl. Phys. Lett, 82, 2422 (2003) |
| | 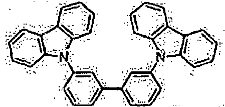 | US20070190359 |
| Dibenzothiophene/Dibenz ofuran-carbazole compounds | 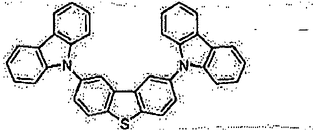 | WO2006114966, US20090167162 |
| | 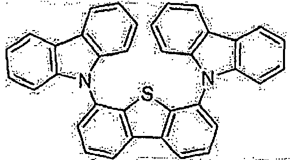 | US20090167162 |
| | 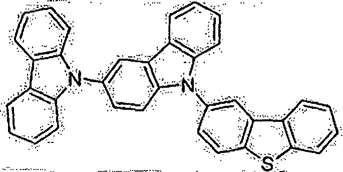 | WO2009086028 |
| | 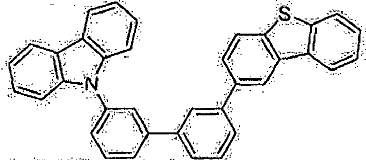 | US20090030202, US20090017330 |
| Silicon aryl compounds | 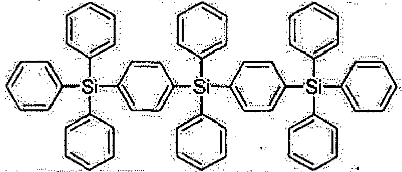 | US20050238919 |
| | 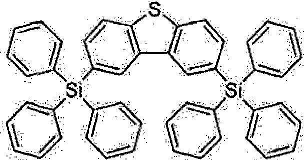 | WO2009003898 |
| Silicon/Germanium aryl compounds | 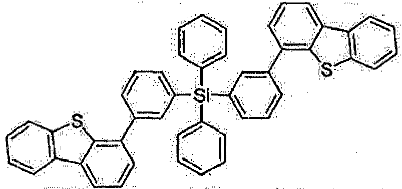 | EP2034538A |
| Aryl benzoyl ester | 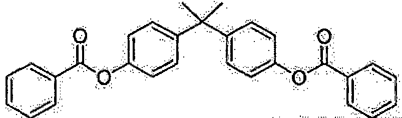 | WO2006100298 |
| High triplet metal organometallic complex | 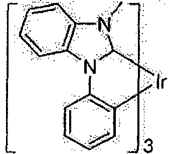 | US7154114 |

| **Phosphorescent dopants** | | |
|---|---|---|
| **Red dopants** | | |
| Heavy metal porphyrins (e.g., PtOEP) | 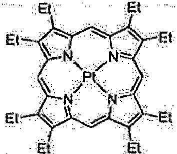 | Nature 395, 151 (1998) |
| Iridium(III) organometallic complexes | 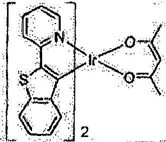 | Appl. Phys. Lett. 78, 1622 (2001) |
| | 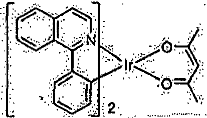 | US2006835469 |
| | 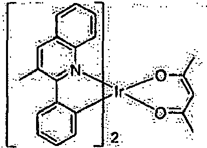 | US2006835469 |
| | 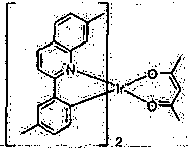 | US20060202194 |
| | 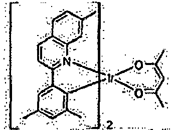 | US20060202194 |
| | 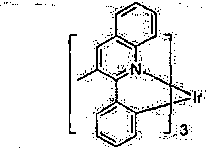 | US20070087321 |
| | 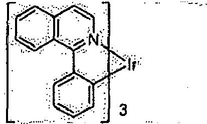 | US20070087321 |
| | 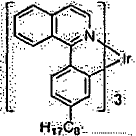 | Adv. Mater. 19, 739 (2007) |
| | 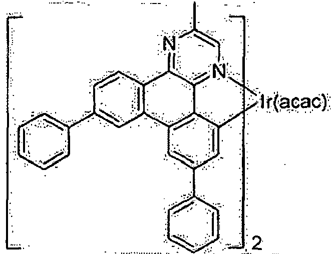 | WO2009100991 |
| | 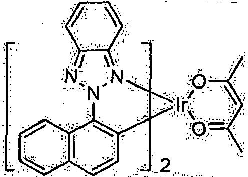 | WO2008101842 |
| Platinum(II) organometallic complexes | 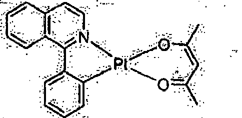 | WO2003040257 |
| Osminum(III) complexes | 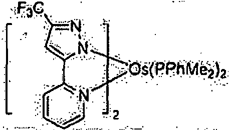 | Chem. Mater. 17, 3532 (2005) |
| Ruthenium(II) complexes | 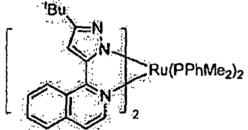 | Adv. Mater. 17, 1059 (2005) |
| Rhenium (I), (II), and (III) complexes | 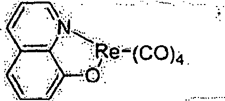 | US20050244673 |

| **Green dopants** | | |
|---|---|---|
| Iridium(III) organometallic complexes | 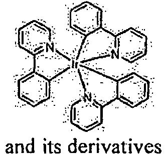 | Inorg. Chem. 40, 1704 (2001) |
| | 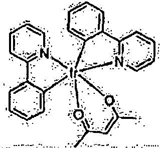 | US20020034656 |
| | 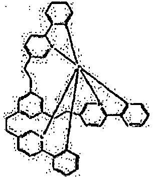 | US7332232 |
| | 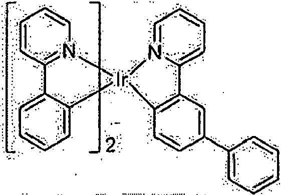 | US20090108737 |
| | 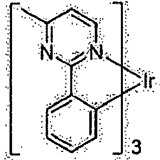 | US20090039776 |
| | 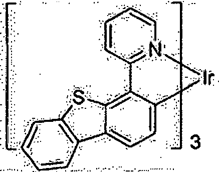 | US6921915 |
| | 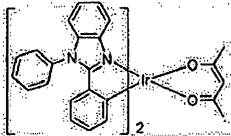 | US6687266 |
| | 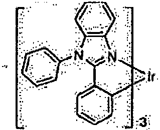 | Chem. Mater. 16, 2480 (2004) |
| | 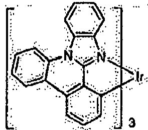 | US20070190359 |
| | 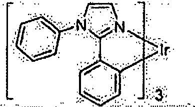 | US20060008670 JP2007123392 |
| | 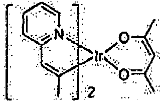 | Adv. Mater. 16, 2003 (2004) |
| | 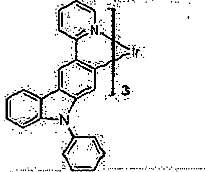 | Angew. Chem. Int. Ed. 2006, 45, 7800 |
| | 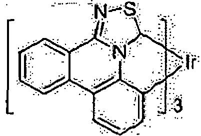 | WO2009050290 |
| | 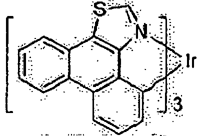 | US20090165846 |
| | 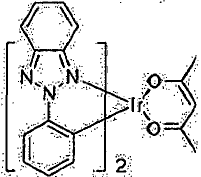 | US20080015355 |
| Monomer for polymeric metal organometallic compounds | 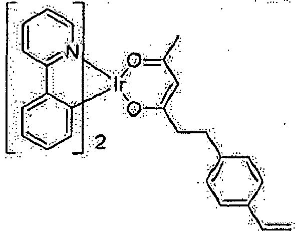 | US7250226, US7396598 |
| Pt(II) organometallic complexes, including polydentated ligands | 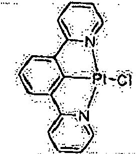 | Appl. Phys. Lett. 86, 153505 (2005) |
| | 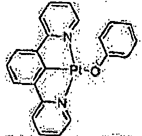 | Appl. Phys. Lett. 86, 153505 (2005) |
| | 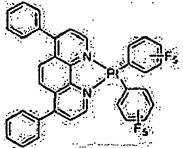 | Chem. Lett. 34, 592 (2005) |
| | 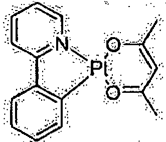 | WO2002015645 |
| | 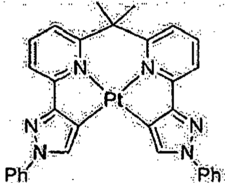 | US20060263635 |
| Cu complexes | 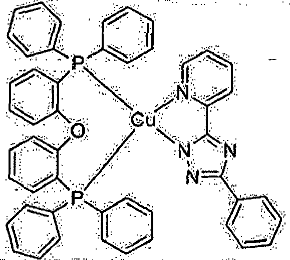 | WO2009000673 |
| Gold complexes | 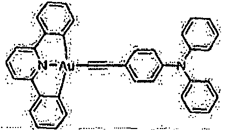 | Chem. Commun. 2906 (2005) |
| Rhenium(III) complexes | 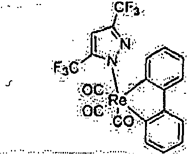 | Inorg. Chem. 42, 1248 (2003) |
| Deuterated organometallic complexes | 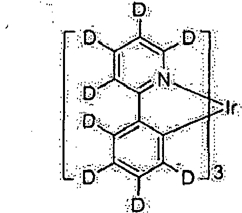 | US20030138657 |
| Organometallic complexes with two or more metal centers | 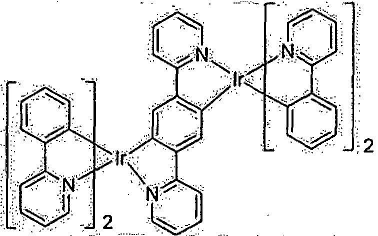 | US20030152802 |
| | 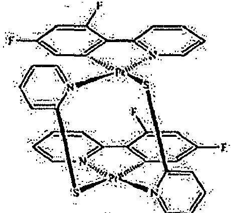 | US7090928 |

| **Blue dopants** | | |
|---|---|---|
| Iridium(III) organometallic complexes | 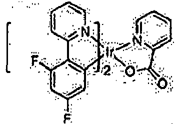 | WO2002002714 |
| | 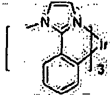 | WO2006009024 |
| | 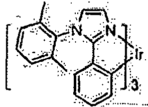 | US20060251923 |
| | 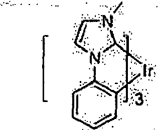 | US7393599, WO2006056418, US20050260441, WO2005019373 |
| | 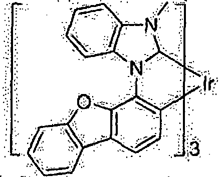 | US7534505 |
| | 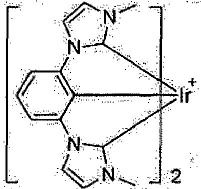 | US7445855 |
| | 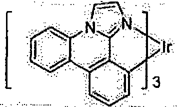 | US20070190359, US20080297033 |
| | 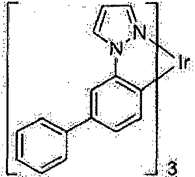 | US7338722 |
| | 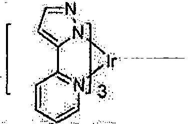 | US20020134984 |
| | 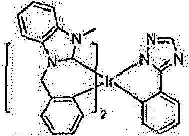 | Angew. Chem. Int. Ed. 47, 1(2008) |
| | 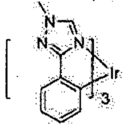 | Chem. Mater. 18, 5119 (2006) |
| | 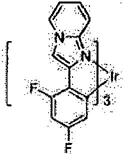 | Inorg. Chem. 46, 4308 (2007) |
| | 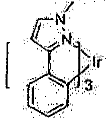 | WO20051238 |
| | 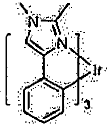 | WO2005123873 |
| | 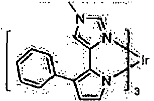 | WO2007004380 |
| | 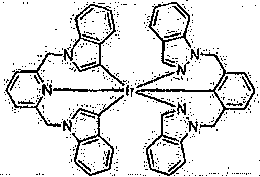 | WO2006082742 |
| Osmium(II) complexes | 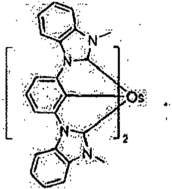 | US7279704 |
| | 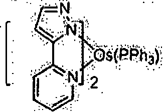 | Organometallics 23, 3745 (2004) |
| Gold complexes | 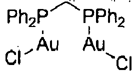 | Appl. Phys. Lett.74,1361 (1999) |
| Platinum(II) complexes | 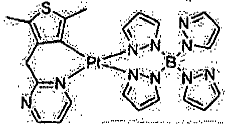 | WO2006098120, WO2006103874 |

| **Exciton/hole blocking layer materials** | | |
|---|---|---|
| Bathocuprine compounds (e.g., BCP, BPhen) | 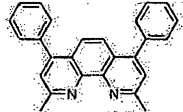 | Appl. Phys. Lett. 75, 4 (1999) |
| | 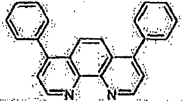 | Appl. Phys. Lett. 79, 449 (2001) |
| Metal 8-hydroxyquinolates (e.g., BAlq) | 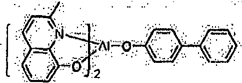 | Appl. Phys. Lett. 81, 162(2002) |
| 5-member ring electron deficient heterocycles such as triazole, oxadiazole, imidazole, benzoimidazole | 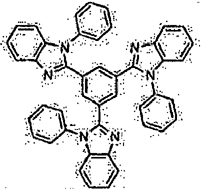 | Appl. Phys. Lett. 81, 162 (2002) |
| triphenylene compounds | 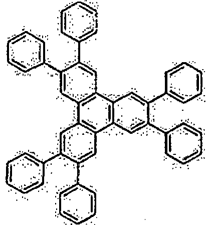 | US20050025993 |
| Fluorinated aromatic compounds | 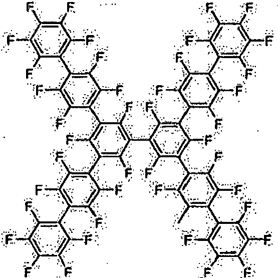 | Appl. Phys. Lett. 79, 156 (2001) |
| Phenothiazine-S-oxide | 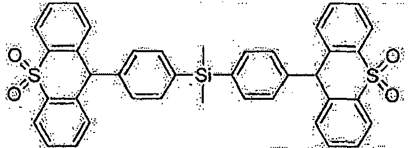 | WO2008132085 |

| **Electron transporting materials** | | |
|---|---|---|
| Anthracene-benzoimidazole compounds | 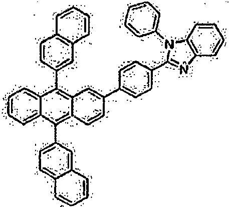 | WO2003060956 |
| | 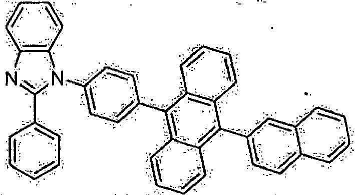 | US20090179554 |
| Aza triphenylene derivatives | 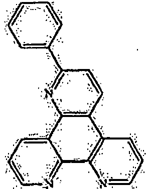 | US20090115316 |
| Anthracene-benzothiazole compounds | 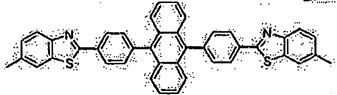 | Appl. Phys. Lett. 89, 063504 (2006) |
| Metal 8-hydroxyquinolates (e.g., Alq₃, Zrq₄) | 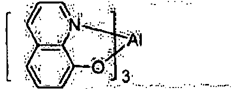 | Appl. Phys. Lett. 51, 913(1987) US7230107 |
| Metal hydroxybenoquinolates | 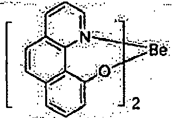 | Chem. Lett. 5, 905 (1993) |
| Bathocuprine compounds such as BCP, BPhen, etc | 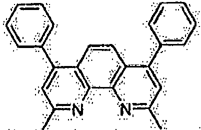 | Appl. Phys. Lett. 91, 263503 (2007) |
| | 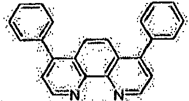 | Appl. Phys. Lett. 79, 449(2001) |
| 5-member ring electron deficient heterocycles (e.g.,triazole, oxadiazolc, imidazole, benzoimidazole) | 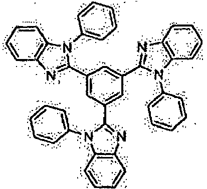 | Appl. Phys. Lett. 74, 865 (1999) |
| | 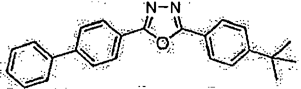 | Appl. Phys. Lett. 55, 1489 (1989) |
| | 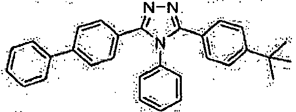 | Jpn. J. Apply. Phys. 32, L917 (1993) |
| Silole compounds | 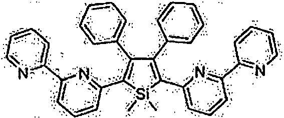 | Org. Electron. 4, 113 (2003) |
| Arylborane compounds | 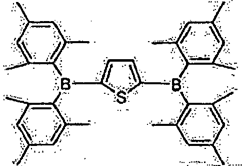 | J. Am. Chem. Soc. 120, 9714 (1998) |
| Fluorinated aromatic compounds | 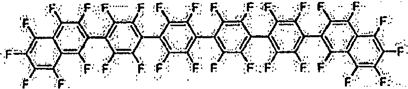 | J. Am. Chem. Soc. 122, 1832 (2000) |
| Fullerene (e.g., C60) | 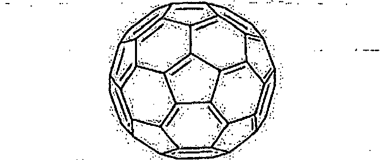 | US20090101870 |
| Triazine complexes | 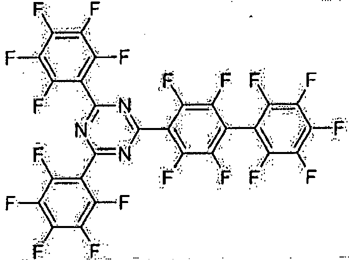 | US20040036077 |
| Zn (N^N) complexes | 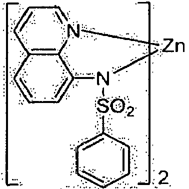 | US6528187 |

### EXPERIMENTAL

Chemical abbreviations used throughout this document are as follows: Cy is cyclohexyl, dba is dibenzylideneacetone, EtOAc is ethyl acetate, DME is dimethoxyethane, dppf is 1,1'-bis(diphenylphosphino)ferrocene, S-Phos is dicyclohexyl(2',6'-dimethoxy-[1,1'-biphenyl]-2-yl)phosphine.

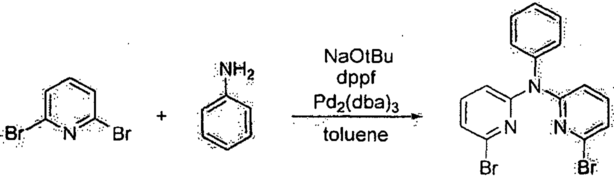

Synthesis of 6-bromo-N-(6-bromopyridin-2-yl)-N-phenylpyridin-2-amine: To a 500 mL 3-neck round-bottom flask was added 2,6-dibromopyridine (20 g, 84 mmol), aniline (3.1 mL, 33.8 mmol), dppf (0.749 g, 1.351 mmol), sodium t-butoxide (8.11 g, 84 mmol), and 250 mL toluene. Nitrogen was bubbled directly into the reaction mixture. Pd₂(dba)₃ (0.62 g, 0.68 mmol) was added to the reaction mixture which was heated to reflux overnight. The reaction mixture was cooled and diluted with ethyl acetate and water and filtered through Celite® to remove insoluble material. The layers were separated and the aqueous layer extracted with ethyl acetate. The organic layers were washed with brine, dried over magnesium sulfate, filtered, and evaporated. The residue was purified by column chromatography eluting with dichloromethane to give 6-bromo-*N*-(6-bromopyridin-2-yl)-*N*-phenylpyridin-2-amine (6.3 g, 46%).

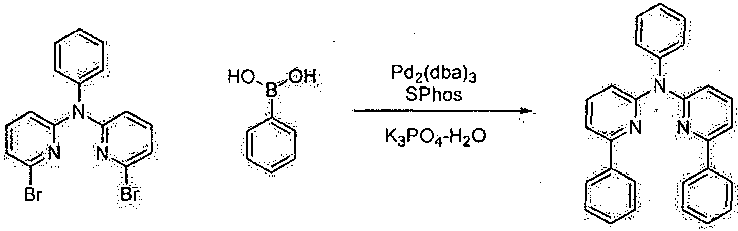

6-Bromo-N-(6-bromopyridin-2-yl)-N-phenylpyridin-2-amine (7 g, 17.3 mmol), phenylboronic acid (5.3 g, 43.2 mmol), Pd₂(dba)₃ (0.32 g, 0.35 mmol), dicyclohexyl(2',6'-dimethoxy-[1,1'-biphenyl]-2-yl)phosphine (0.57 g, 1.38 mmol), potassium phosphate tribasic monohydrate (11.94 g, 51.8 mmol), toluene (200 mL) and water (20 mL) were added to a flask and degassed with nitrogen. The reaction mixture was heated to reflux for 16 h before being cooled to room temperature. Water was added and the layers separated, washing the aqueous twice with EtOAc and combined organics with water and brine. After removal of the solvent, the crude product was chromatographed on silica gel with 9/1 (v/v) hexane/EtOAc to give 5.6 g of a white solid, which was recrystallized from hexane to give 5.1 g of pure (HPLC purity: 100%) product as confirmed by NMR and GC/MS.

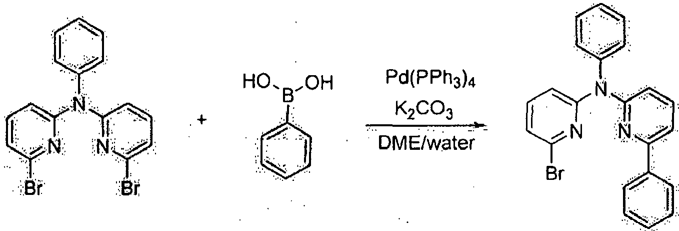

**Synthesis of 6-bromo-*N*-phenyl-*N*-(6-phenylpyridin-2-yl)pyridine-2-amine:** To a 1 L 3-neck round-bottom flask was added 6-bromo-N-(6-bromopyridin-2-yl)-N-phenylpyridin-2-amine (5.3 g, 13.08 mmol), phenylboronic acid (1.595 g, 13.08 mmol), potassium carbonate (5.42 g, 39.3 mmol), 200 mL dimethoxyethane and 100 mL water. Nitrogen was bubbled directly into the mixture. Pd(PPh₃)₄ (0.151 g, 0.131 mmol) was added and the reaction mixture was heated to 105 °C overnight under nitrogen. The reaction mixture was diluted with ethyl acetate and water. The layers were separated and the aqueous layer extracted with ethyl acetate. The organic layers were dried over magnesium sulfate, filtered, and evaporated leaving a yellow oil. The material was purified by column chromatography using a reverse phase column eluting with 80/20 (v/v) acetonitrile/water to give 6-bromo-*N*-phenyl-*N*-(6-phenylpyridin-2-yl)pyridine-2-amine (2.84 g, 45%).

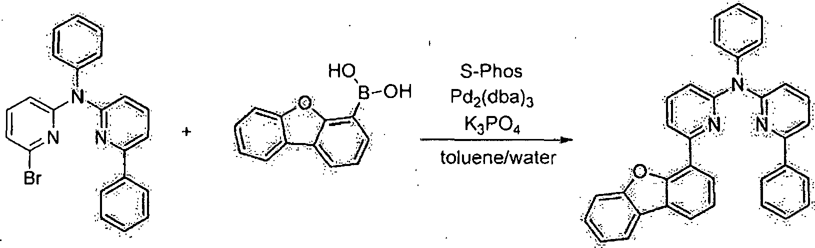

Synthesis of 6-(dibenzo[*b*,*d*]furan-4-yl)-*N*-phenyl-*N*-(6-phenylpyridin-2-yl)pyridine-2-amine: To a 300 mL 3-neck flask was added 6-bromo-*N*-phenyl-*N*-(6-phenylpyridin-2-yl)pyridin-2-amine (2.5 g, 6.21 mmol), dibenzo[b,d]furan-4-ylboronic acid (1.6 g, 7.5 mmol), potassium phosphate, monohydrate (4.3 g, 18.6 mmol), dicyclohexyl(2',6'-dimethoxy-[1,1'-biphenyl]-2-yl)phosphine (S-Phos) (0.102 g, 0.249 mmol), 100 mL toluene, and 10 mL water. Nitrogen was bubbled directly into the mixture. Pd₂(dba)₃ (0.057 g, 0.062 mmol) was added and the reaction mixture heated to reflux overnight under nitrogen. Water was added to the reaction mixture and the layers were separated. The aqueous layer was extracted with ethyl acetate. The organic layers were washed with brine, dried over magnesium sulfate, filtered, evaporated. The material was purified by column chromatography eluting with 8/2/2.5 hexane/dichloromethane/ ethyl acetate to give 6-(dibenzo[*b,d*]furan-4-yl)-*N-*phenyl-*N*-(6-phenylpyridin-2-yl)pyridine-2-amine (2.7 g, 88%).

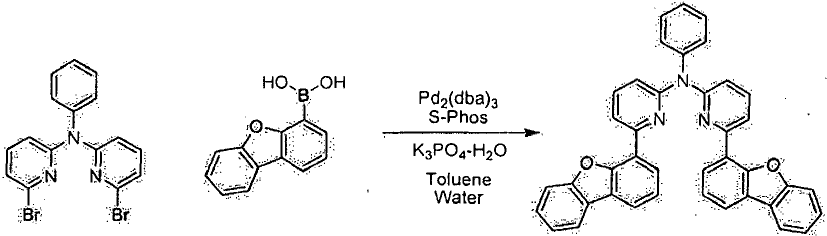

Synthesis of 6-(dibenzo[*b*,*d*]furan-4-yl)-N-(6-(dibenzo[b,d]furan-4-yl)pyridin-2-yl)-N-phenylpyridin-2-amine: To a 500 mL 3-neck round-bottom flask was added 6-bromo-N-(6-bromopyridin-2-yl)-N-phenylpyridin-2-amine (4.4 g, 10.9 mmol), dibenzo[*b,d*]furan-4-ylboronic acid (5.1 g, 23.9 mmol), Pd₂(dba)₃ (0.10 g, 0.11 mmol), dicyclohexyl(2',6'-dimethoxy-[1,1'-biphenyl]-2-yl)phosphine (0.18 g, 0.43 mmol), and potassium phosphate tribasic monohydrate (12.5 g, 54.3 mmol) in toluene (100 mL) and water (10 mL). Nitrogen was bubbled directly into the reaction mixture for 20 min. and the reaction heated to reflux for 16 h. The reaction mixture was cooled and diluted with ethyl acetate and water and filtered through Celite to remove insoluble material. The layers were separated and the aqueous layer extracted with dichloromethane. The organic layers were washed with brine, dried over magnesium sulfate, filtered, and evaporated. The residue was purified by column chromatography eluting with 95/5 dichloromethane/ethyl acetate to give 2.1 g (87%) of 6-(dibenzo[*b*,*d*]furan-4-yl)-N-(6-(dibenzo[*b*,*d*]furan-4-yl)pyridin-2-yl)-N-phenylpyridin-2-amine as a white solid. The product was confirmed by LC/MS, NMR and HPLC (purity: 99.96%).

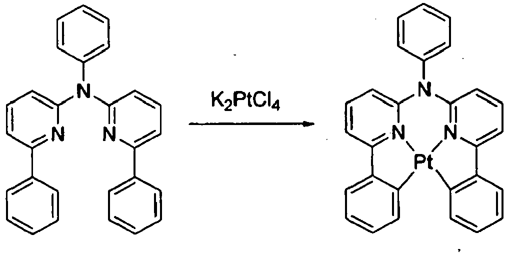

Synthesis of Compound X: N,6-Diphenyl-N-(6-phenylpyridin-2-yl)pyridin-2-amine (1.9 g, 4.8 mmol) and potassium tetrachloroplatinate (1.97 g, 4.8 mmol) were mixed in 100 mL of acetic acid. The mixture was degassed with nitrogen sparge for 20 min. and heated to 140 °C for 4 days. After cooling, water was added and the solid was collected by filtration. The solid was washed of the frit with dichloromethane to give a yellow filtrate that was dried over sodium sulfate and the solvent removed. The crude product was purified by column on silica using dichloromethane as solvent to give 1.1g of the platinum complex. The complex was sublimed (260 °C, 10⁻⁵ Torr (1.33x10⁻³Pa)) to give 0.8 g of Compound X as a yellow solid (HPLC purity: 99.3%) as confirmed by NMR and LC/MS.

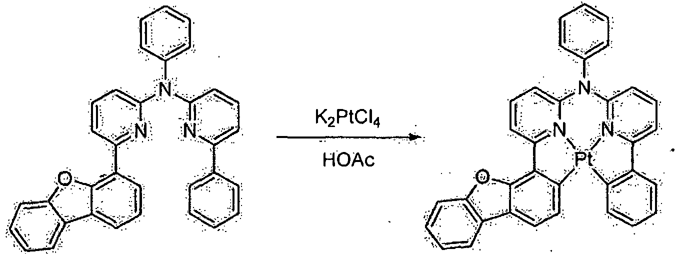

Synthesis of Compound 4: To a 300 mL 3-neck round bottom flask was added K₂PtCl₄ (2.1 g, 5.0 mmol), 6-(dibenzo[*b*,*d*]furan-4-yl)-*N*-phenyl-*N*-(6-phenylpyridin-2-yl)pyridin-2-amine (2.7 g, 5.5 mmol), and 100 mL acetic acid. The reaction mixture was purged with nitrogen for 20 minutes. The reaction mixture was heated to 140 °C under nitrogen for 3 days, cooled, and diluted with hexane. A green solid was filtered off and washed with hexane. The material was purified by column chromatography eluting with 60/40 to 70/40 (v/v) dichloromethane/hexane followed by sublimation overnight at 300 °C to yield 0.58 g (17%) of Compound as a yellow solid. The product was confirmed by LC/MS and HPLC (99.1% pure).

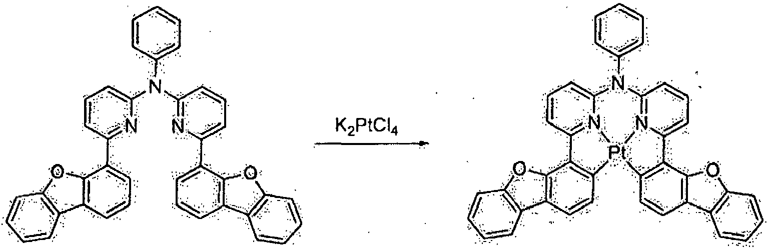

Synthesis of Compound 13: 6-(Dibenzo[*b*,*d*]furan-4-yl)-N-(6-(dibenzo[*b,d*]furan-4-yl)pyridin-2-yl)-N-phenylpyridin-2-amine (1.8 g, 3.1 mmol) and K₂PtCl₄ (1.3 g, 3.1 mmol) were mixed in 100 mL of acetic acid. The mixture was bubbled with nitrogen for 20 min. before being heated to 140 °C for 4 days. After cooling, water was added and the solid collected by filtration. The solid was washed with dichloromethane to give a yellow filtrate that was concentrated to give a yellow solid. The solid was suspended in dichloromethane and methanol was added to give a precipitate that was filtered and washed with methanol and hexane and dried to give 0.88 g (37%) of Compound 13 as an orange solid. The product was confirmed by LC/MS and HPLC (99.1% pure).

It is understood that the various embodiments desribed herein are by way of example only, and are not intended to limit the scope of the invention. The present invention as claimed may therefore include variations from the particular examples and preferred embodiments described herein, as will be apparent to one of skill in the art. It is understood that various theories as to why the invention works are not intended to be limiting.

The following numbered paragraphs describe embodiments of the invention:
1. A compound having the formula: 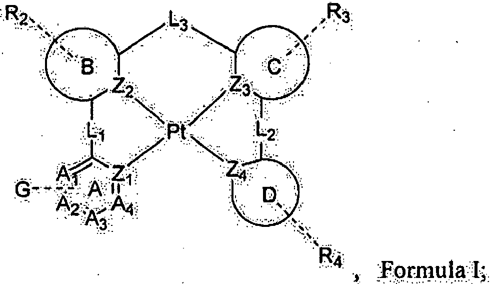 wherein G has the structure: 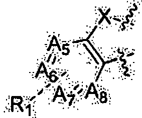 and wherein G is fused to any two adjacent carbon atoms on ring A;
   wherein ring B, ring G, and ring D are 5- or 6-membered carbocyclic or heterocyclic aromatic rings;
   wherein L₁, L₂, and L₃ are independently selected from the group consisting of a single bond, BR, NR, PR, O, S, Se, C=O, S=O, SO₂, CRR', SiRR', and GeRR';
   wherein at least one of L₁, L₂, and L₃ is not a single bond;
   wherein X is selected from the group consisting of BR, NR, PR, O, S, Se, C=O, S=O, SO₂, CRR', SiRR', and GeRR';
   wherein Z₁, Z₂, Z₃, and Z₄ are nitrogen or carbon atoms;
   wherein A₁, A₂, A₃, A₄, A₅, A₆, A₇, and A₈ comprise carbon or nitrogen;
   wherein R₁, R₂, R₃, and R₄ independently represent mono-, di-, tri-, or tetra-substitution;
   wherein R₁ is optionally fused, R₂ is optionally fused to ring B, R₃ is optionally fused to ring C, and R₄ is optionally fused to ring D;
   wherein R₃ and R₄ are optionally linked to form a ring;
   wherein if L₂ is not a single bond, R₃ and L₂ or R₄ and L₂ are optionally linked to form a ring; and
   wherein R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.
2. The compound of paragraph 1, wherein the compound has a neutral charge.
3. The compound of paragraph 1, wherein at least two of Z₁, Z₂, Z₃, and Z₄ are nitrogen atoms.
4. The compound of paragraph 1, wherein at least two of Z₁, Z₂, Z₃, and Z₄ are carbon atoms.
5. The compound of paragraph 1, wherein at least one of ring B, ring C, and ring D comprises a carbene ligand coordinated to Pt.
6. The compound of paragraph 1, wherein at least one of Z₁, A₁, A₂, A₃, A₄, A₅, A₆, A₇, and A₈ is a nitrogen atom.
7. The compound of paragraph 1, having the formula: 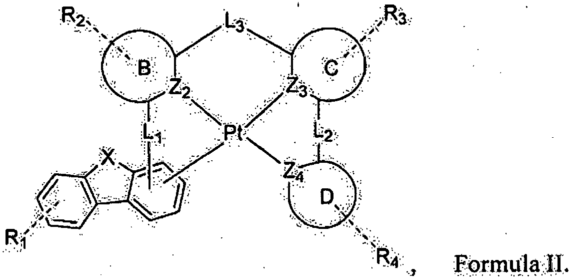
8. The compound of paragraph 7, having the formula: 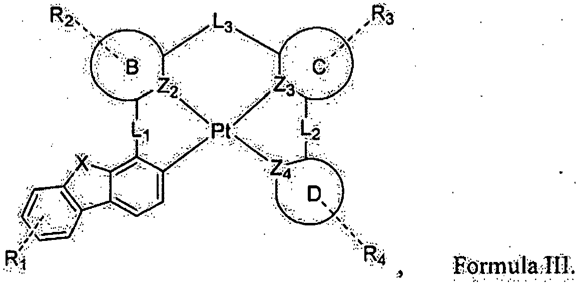
9. The compound having the formula: 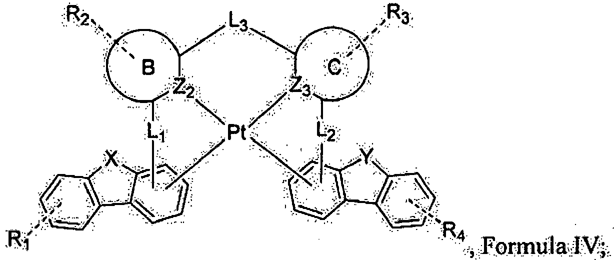 wherein Y is selected from the group consisting of BR, NR, PR, O, S, Se, C=O, S=O, SO₂, CRR', SiRR', and GeRR'.
10. The compound of paragraph 9, having the formula: 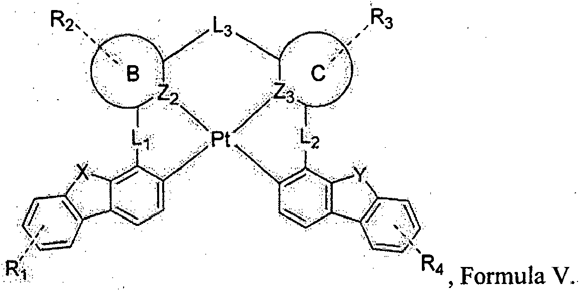
11. The compound of paragraph 1, wherein L₁ and L₂ are single bonds.
12. The compound of paragraph 1, wherein L₃ is independently selected from the group consisting of O, S, and NR.
13. The compound of paragraph 12, wherein L₃ is NR, and R is phenyl or substituted phenyl.
14. The compound of paragraph 12, wherein L₃ is O.
15. The compound of paragraph 1, wherein Z₂ and Z₃ are nitrogen atoms.
16. The compound of paragraph 1, wherein Z₂ and Z₄ are nitrogen atoms.
17. The compound of paragraph 8, wherein X is independently selected from the group consisting of O, S, and NR.
18. The compound of paragraph 17, wherein X is O.
19. The compound of paragraph 1 and 9, wherein the compound is selected from the group consisting of: 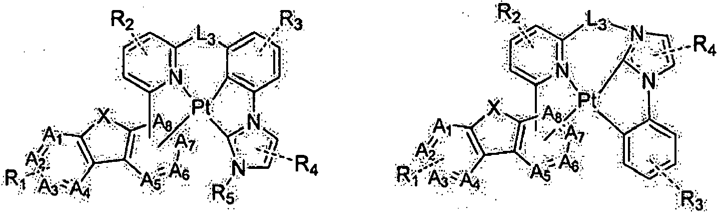 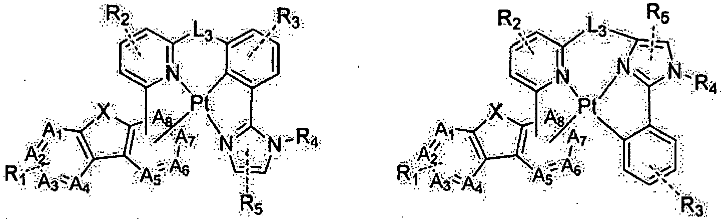 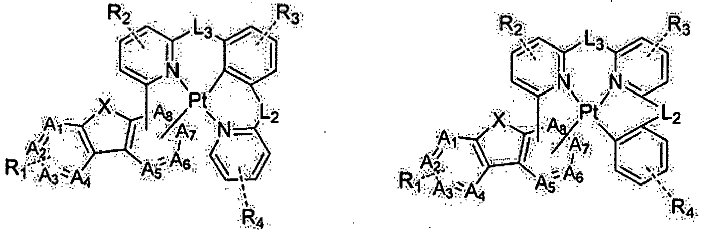 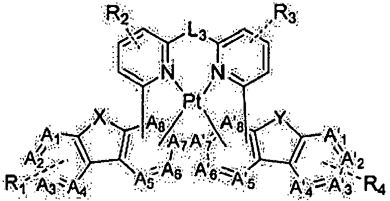 wherein Y is selected from the group consisting of BR, NR, PR, O, S, Se, C=O, S=O, SO₂, CRR', SiRR', and GeRR';
   wherein A₁', A₂', A₃', A₄', A₅', A₆', A₇', and A₈' comprise carbon or nitrogen;
   wherein at most one of A₁, A₂, A₃, A₄ is nitrogen;
   wherein at most one of A₅, A₆, A₇, A₈ is nitrogen, and the nitrogen is not bound to Pt;
   wherein at most one of A₁', A₂', A₃', A₄' is nitrogen;
   wherein at most one of A₅', A₆', A₇', A₈' is nitrogen, and the nitrogen is not bound to Pt;
   wherein the Pt forms at least two Pt-C bonds;
   wherein R₃ and R₄ may be fused together to form a ring;
   wherein R₅ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.
20. A first device comprising a first organic light emitting device, further comprising:
   an anode;
   a cathode; and
   an organic layer, disposed between the anode and the cathode, comprising a compound having the formula: 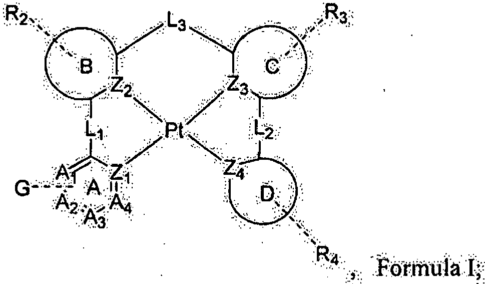
   wherein G has the structure: 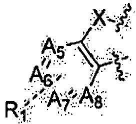 and wherein G is fused to any two adjacent carbon atoms on ring A;
   wherein ring B, ring C, and ring D are 5- or 6-membered carbocyclic or heterocyclic aromatic rings;
   wherein L₁, L₂, and L₃ are independently selected from the group consisting of a single bond, BR, NR, PR, O, S, Se, C=O, S=O, SO₂, CRR', SiRR', and GeRR';
   wherein at least one of L₁, L₂, and L₃ is not a single bond;
   wherein X is selected from the group consisting of BR, NR, PR, O, S, Se, C=O, S=O, SO₂, CRR', SiRR', and GeRR';
   wherein Z₁, Z₂, Z₃, and Z₄ are nitrogen or carbon atoms;
   wherein A₁, A₂, A₃, A₄, A₅, A₆, A₇, and A₈ comprise carbon or nitrogen;
   wherein R₁, R₂, R₃, and R₄ independently represent mono-, di-, tri-, or tetra-substitution;
   wherein R₁ is optionally fused, R₂ is optionally fused to ring B, R₃ is optionally fused to ring C, and R₄ is optionally fused to ring D; and
   wherein R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.
21. The first device of paragraph 20, wherein the first device is a consumer product.
22. The first device of paragraph 20, wherein the first device is an organic light-emitting device.
23. The first device of paragraph 20, wherein the first device comprises a lighting panel.
24. The first device of paragraph 20, wherein the organic layer is an emissive layer and the compound is an emissive dopant.
25. The first device of paragraph 20, wherein the organic layer is an emissive layer and the compound is a non-emissive dopant.
26. The first device of paragraph 20, wherein the organic layer further comprises a host.
27. The first device of paragraph 26, wherein the host comprises a triphenylene containing benzo-fused thiophene or benzo-fused furan;
   wherein any substituent in the host is an unfused substituent independently selected from the group consisting of CₙH₂ₙ₊₁, OCₙH₂₊₁, OAr₁, N(CₙH₂ₙ₊₁)₂, N(Ar₁)(Ar₂), CH=CH-CₙH₂ₙ₊₁, C≡CHCₙH₂ₙ₊₁, Ar₁, Ar₁-Ar₂, CₙH₂ₙ-Ar₁, or no substitution;
   wherein n is from 1 to 10; and
   wherein Ar₁ and Ar₂ are independently selected from the group consisting of benzene, biphenyl, naphthalene, triphenylene, carbazole, and heteroaromatic analogs thereof.
28. The first device of paragraph 27, wherein the host has the formula: 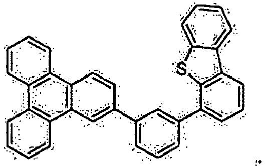
29. The first device of paragraph 26, wherein the host is selected from the group consisting of 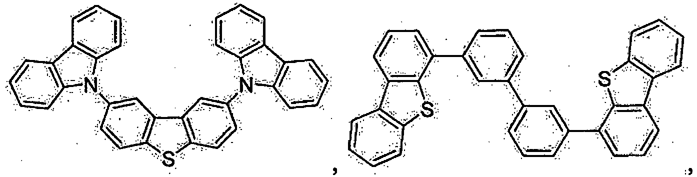 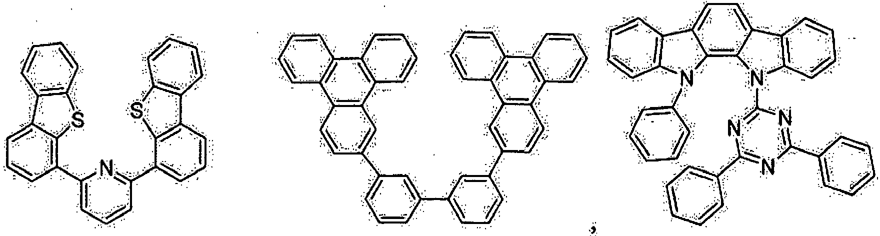 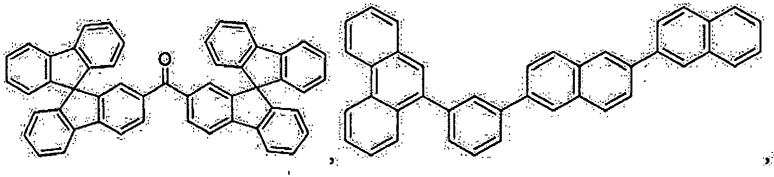 and combinations thereof.
30. The first device of paragraph 26, wherein the host is a metal complex.

## Claims

1. A compound having the formula: 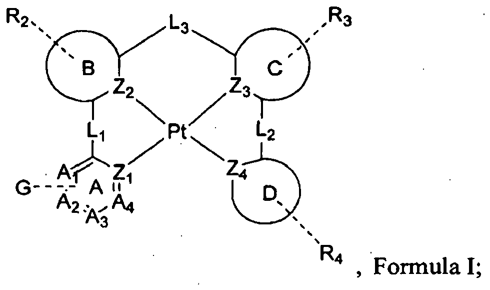 wherein G has the structure: 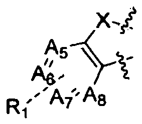 and wherein G is fused to any two adjacent carbon atoms on ring A;
wherein ring B, ring C, and ring D are 5- or 6-membered carbocyclic or heterocyclic aromatic rings;
wherein L₁, L₂, and L₃ are independently selected from the group consisting of a single bond, BR, NR, PR, O, S, Se, C=O, S=O, SO₂, CRR', SiRR', and GeRR';
wherein at least one of L₁, L₂, and L₃ is not a single bond;
wherein X is selected from the group consisting of BR, NR, PR, O, S, Se, C=O, S=O, SO₂, CRR', SiRR', and GeRR';
wherein Z₁, Z₂, Z₃, and Z₄ are nitrogen or carbon atoms;
wherein A₁, A₂, A₃, A₄, A₅, A₆, A₇, and A₈ comprise carbon or nitrogen;
wherein R₁, R₂, R₃, and R₄ independently represent mono-, di-, tri-, or tetra-substitution;
wherein R₁ is optionally fused, R₂ is optionally fused to ring B, R₃ is optionally fused to ring C, and R₄ is optionally fused to ring D;
wherein R₃ and R₄ are optionally linked to form a ring;
wherein if L₂ is not a single bond, R₃ and L₂ or R₄ and L₂ are optionally linked to form a ring; and
wherein R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

2. The compound of claim 1, wherein the compound has a neutral charge.

3. The compound of claim 1, wherein at least two of Z₁, Z₂, Z₃, and Z₄ are nitrogen atoms.

4. The compound of claim 1, wherein at least two of Z₁, Z₂, Z₃, and Z₄ are carbon atoms.

5. The compound of claim 1, wherein at least one of ring B, ring C, and ring D comprises a carbene ligand coordinated to Pt.

6. The compound of claim 1, wherein at least one of Z₁, A₁, A₂, A₃, A₄, A₅, A₆, A₇, and A₈ is a nitrogen atom.

7. The compound of claim 1, having the formula:

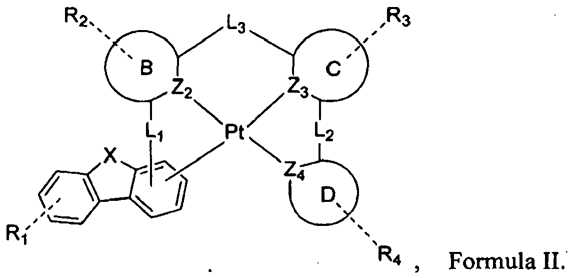

8. The compound of claim 7, having the formula:

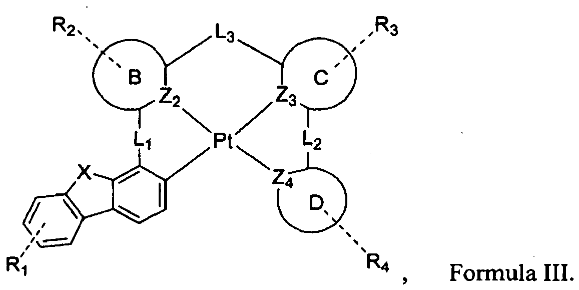

9. A compound having the formula: 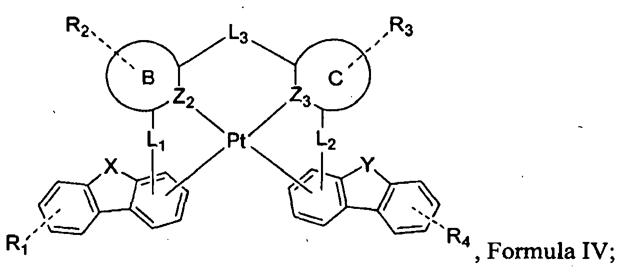 wherein ring B, and ring C are 5- or 6-membered carbocyclic or heterocyclic aromatic rings;
wherein L₁, L₂, and L₃ are independently selected from the group consisting of a single bond, BR, NR, PR, O, S, Se, C=O, S=O, SO₂, CRR', SiRR', and GeRR';
wherein at least one of L₁, L₂, and L₃ is not a single bond;
wherein X is selected from the group consisting of BR, NR, PR, O, S, Se, C=O, S=O, SO₂, CRR', SiRR', and GeRR';
wherein Z₂, and Z₃ are nitrogen or carbon atoms;
wherein R₁, R₂, R₃, and R₄ independently represent mono-, di-, tri-, or tetra-substitution;
wherein R₁ is optionally fused, R₂ is optionally fused to ring B, R₃ is optionally fused to ring C, and R₄ is optionally fused to ring D;
wherein R₃ and R₄ are optionally linked to form a ring;
wherein if L₂ is not a single bond, R₃ and L₂ or R₄ and L₂ are optionally linked to form a ring; and
wherein R, R', R₁, R₂, R₃, and R₄ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and
wherein Y is selected from the group consisting of BR, NR, PR, O, S, Se, C=O, S=O, SO₂, CRR', SiRR', and GeRR'.

10. The compound of claim 9, having the formula:

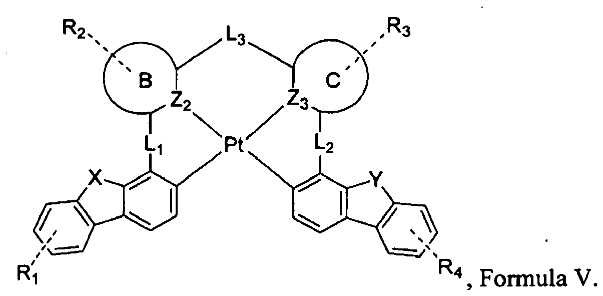

11. The compound of claim 1, wherein L₁ and L₂ are single bonds.

12. The compound of claim 1, wherein L₃ is independently selected from the group consisting of O, S, and NR.

13. The compound of claim 1, wherein Z₂ and Z₃ are nitrogen atoms.

14. The compound of claim 1, wherein Z₂ and Z₄ are nitrogen atoms.

15. The compound of claim 1 and 9, wherein the compound is selected from the group consisting of: 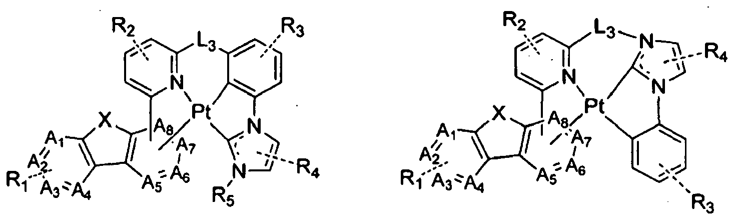 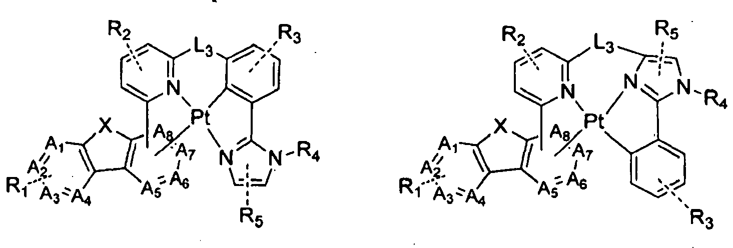 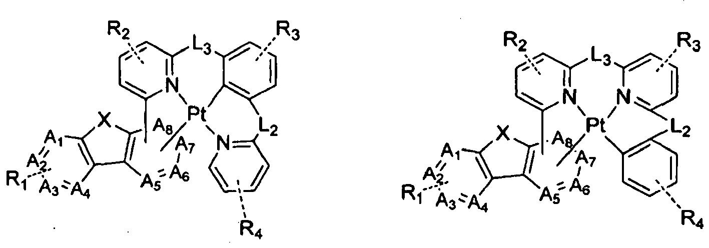 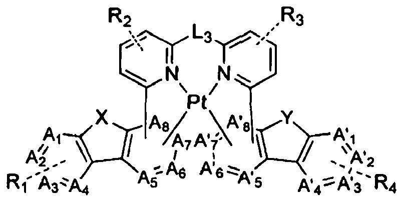 wherein Y is selected from the group consisting of BR, NR, PR, O, S, Se, C=O, S=O, SO₂, CRR', SiRR', and GeRR';
wherein A₁', A₂', A₃', A₄', A₅, A₆', A₇', and A₈' comprise carbon or nitrogen;
wherein at most one of A₁, A₂, A₃, A₄ is nitrogen;
wherein at most one of A₅, A₆, A₇, A₈ is nitrogen, and the nitrogen is not bound to Pt;
wherein at most one of A₁', A₂', A₃', A₄' is nitrogen;
wherein at most one of A₅', A₆', A₇', A₈' is nitrogen, and the nitrogen is not bound to Pt;
wherein the Pt forms at least two Pt-C bonds;
wherein R₃ and R₄ may be fused together to form a ring;
wherein R₅ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

16. A first device comprising a first organic light emitting device, further comprising:
an anode;
a cathode; and
an organic layer, disposed between the anode and the cathode, comprising a compound as defined in any one of the previous claims.

## Patentansprüche

1. Verbindung mit folgender Formel: 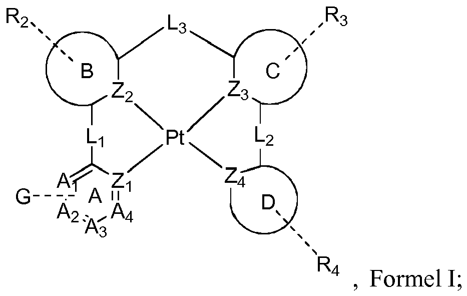 wobei G folgende Struktur aufweist: 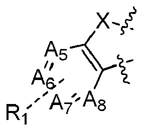 und wobei G an zwei beliebige benachbarte Kohlenstoffatome am Ring A anneliert ist;
wobei Ring B, Ring C, und Ring D 5- oder 6-gliedrige carbozyklische oder heterozyklische aromatische Ringe sind;
wobei L₁, L₂, und L₃ unabhängig voneinander ausgewählt sind aus der Gruppe bestehend aus einer Einfachbindung, BR, NR, PR, O, S, Se, C=O, S=O, SO₂, CRR', SiRR', und GeRR';
wobei mindestens einer von L₁, L₂, und L₃ nicht eine Einfachbindung ist;
wobei X ausgewählt ist aus der Gruppe bestehend aus BR, NR, PR, O, S, Se, C=O, S=O, SO₂, CRR', SiRR', und GeRR';
wobei Z₁, Z₂, Z₃, und Z₄ Stickstoff- oder Kohlenstoffatome sind;
wobei A₁, A₂, A₃, A₄, A₅, A₆, A₇, und A₈ Kohlenstoff oder Stickstoff umfassen;
wobei R₁, R₂, R₃, und R₄ unabhängig voneinander für mono-, di-, tri-, oder tetra-Substitutionen stehen;
wobei R₁ gegebenenfalls anneliert ist, R₂ gegebenenfalls an Ring B anneliert ist, R₃ gegebenenfalls an Ring C anneliert ist, und R₄ gegebenenfalls an Ring D anneliert ist ;
wobei R₃ und R₄ gegebenenfalls miteinander verknüpft sind um einen Ring zu bilden;
wobei wenn L₂ keine Einfachbindung ist, R₃ und L₂ oder R₄ und L₂ gegebenenfalls miteinander verknüpft sind um einen Ring zu bilden; und
wobei R, R', R₁, R₂, R₃, und R₄ unabhängig voneinander ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino, und deren Kombinationen.

2. Verbindung nach Anspruch 1, wobei die Verbindung eine neutrale Ladung aufweist.

3. Verbindung nach Anspruch 1, wobei mindestens zwei aus Z₁, Z₂, Z₃, und Z₄ Stickstoffatome sind.

4. Verbindung nach Anspruch 1, wobei mindestens zwei aus Z₁, Z₂, Z₃, und Z₄ Kohlenstoffatome sind.

5. Verbindung nach Anspruch 1, wobei mindestens einer aus Ring B, Ring C, und Ring D einen Carbenliganden koordiniert an Pt umfasst.

6. Verbindung nach Anspruch 1, wobei mindestens einer aus Z₁, A₁, A₂, A₃, A₄, A₅, A₆, A₇, und A₈ ein Stickstoffatom ist.

7. Verbindung nach Anspruch 1, mit folgender Formel:

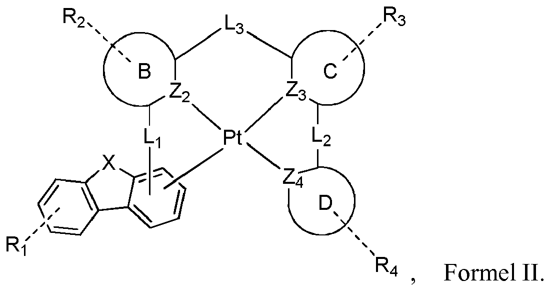

8. Verbindung nach Anspruch 7, mit folgender Formel:

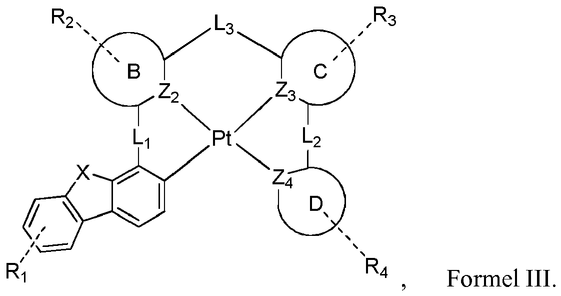

9. Verbindung mit folgender Formel: 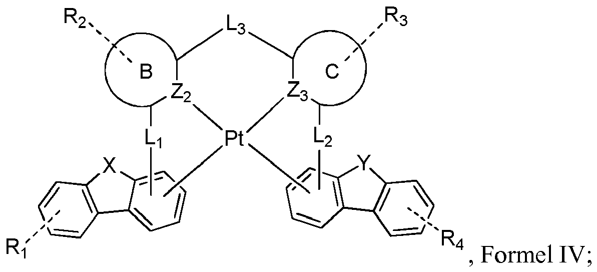 wobei Ring B, und Ring C 5- oder 6-gliedrige carbozyklische oder heterozyklische aromatische Ringe sind;
wobei L₁, L₂, und L₃ unabhängig voneinander ausgewählt sind aus der Gruppe bestehend aus einer Einfachbindung, BR, NR, PR, O, S, Se, C=O, S=O, SO₂, CRR', SiRR', und GeRR';
wobei mindestens einer von L₁, L₂, und L₃ keine Einfachbindung ist;
wobei X ausgewählt ist aus der Gruppe bestehend aus BR, NR, PR, O, S, Se, C=O, S=O, SO₂, CRR', SiRR', und GeRR';
wobei Z₂, und Z₃ Stickstoff- oder Kohlenstoffatome sind;
wobei R₁, R₂, R₃, und R₄ unabhängig voneinander für mono-, di-, tri-, oder tetra-Substitution stehen;
wobei R₁ gegebenenfalls anneliert ist, R₂ gegebenenfalls an Ring B anneliert ist, R₃ gegebenenfalls an Ring C anneliert ist, und R₄ gegebenenfalls an Ring D anneliert ist;
wobei R₃ und R₄ gegebenenfalls miteinander verknüpft sind um einen Ring zu bilden;
wobei wenn L₂ keine Einfachbindung ist, R₃ und L₂ oder R₄ und L₂ gegebenenfalls miteinander verknüpft sind um einen Ring zu bilden; und
wobei R, R', R₁, R₂, R₃, und R₄ unabhängig voneinander ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino, und deren Kombinationen, und
wobei Y ausgewählt ist aus der Gruppe bestehend aus BR, NR, PR, O, S, Se, C=O, S=O, SO₂, CRR', SiRR', und GeRR'.

10. Verbindung nach Anspruch 9 mit folgender Formel:

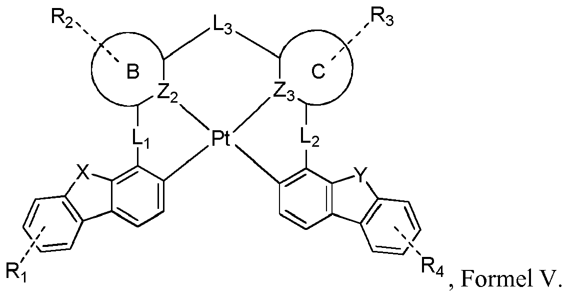

11. Verbindung nach Anspruch 1, wobei L₁ und L₂ Einfachbindungen sind.

12. Verbindung nach Anspruch 1, wobei L₃ unabhängig voneinander ausgewählt ist aus der Gruppe bestehend aus O, S, und NR.

13. Verbindung nach Anspruch 1, wobei Z₂ und Z₃ Stickstoffatome sind.

14. Verbindung nach Anspruch 1, wobei Z₂ und Z₄ Stickstoffatome sind.

15. Verbindung nach Anspruch 1 und 9, wobei die Verbindung ausgewählt ist aus der Gruppe bestehend aus: 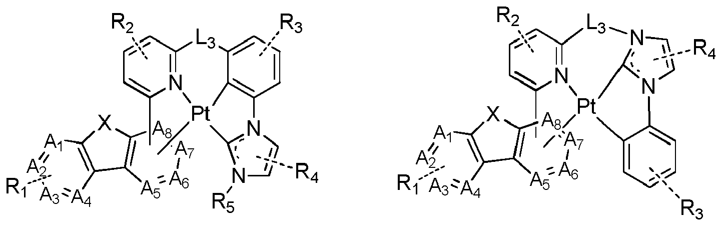 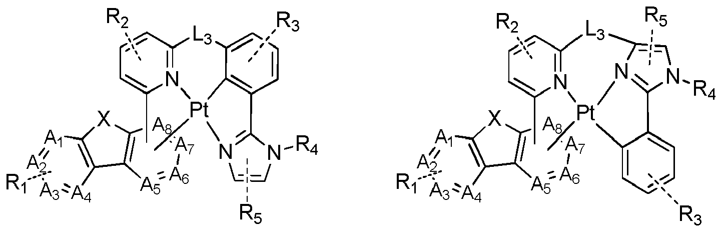 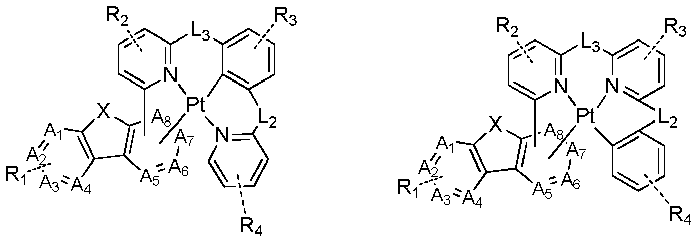 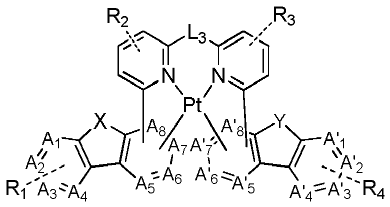 wobei Y ausgewählt ist aus der Gruppe bestehend aus BR, NR, PR, O, S, Se, C=O, S=O, SO₂, CRR', SiRR', und GeRR';
wobei A₁', A₂', A₃', A₄', A₅', A₆', A₇', und A₈' Kohlenstoff oder Stickstoff umfassen;
wobei höchstens einer von A₁, A₂, A₃, A₄ Stickstoff ist;
wobei höchstens einer von A₅, A₆, A₇, A₈ Stickstoff ist, und der Stickstoff nicht an Pt gebunden ist;
wobei höchstens einer aus A₁', A₂', A₃', A₄' Stickstoff ist;
wobei höchstens einer aus A₅', A₆', A₇', A₈' Stickstoff ist, und der Stickstoff nicht an Pt gebunden ist;
wobei das Pt mindestens zwei Pt-C Bindungen bildet;
wobei R₃ und R₄ miteinander verbunden sind um einen Ring zu bilden;
wobei R₅ ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino, und deren Kombinationen.

16. Erste Vorrichtung umfassend eine erste organische lichtemittierende Vorrichtung, ferner umfassend:
eine Anode;
eine Kathode; und
und eine organische Schicht, angeordnet zwischen der Anode und der Kathode, umfassend eine Verbindung wie in einem der vorhergehenden Ansprüche definiert.

## Revendications

1. Composé étant représenté par la formule : 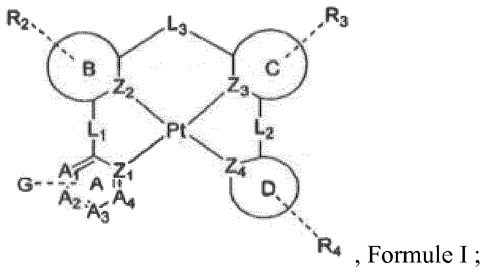 dans laquelle G possède la structure : 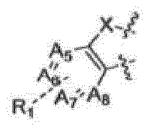 et dans laquelle G est fusionné à deux atomes de carbone adjacents quelconques sur le cycle A ;
dans laquelle le cycle B, le cycle C, et le cycle D sont des cycles aromatiques carbocycliques ou hétérocycliques à 5 ou 6 éléments ;
dans laquelle L₁, L₂, et L₃ sont indépendamment sélectionnés parmi le groupe constitué d'une liaison simple, BR, NR, PR, O, S, Se, C=O, S=O, SO₂, CRR', SiRR', et GeRR' ;
dans laquelle au moins l'un de L₁, L₂, et L₃ n'est pas une liaison simple ;
dans laquelle X est sélectionné parmi le groupe constitué de BR, NR, PR, O, S, Se, C=O, S=O, SO₂, CRR', SiRR', et GeRR' ;
dans laquelle Z₁, Z₂, Z₃, et Z₄ sont des atomes d'azote ou de carbone ;
dans laquelle A₁, A₂, A₃, A₄, A₅, A₆, A₇, et A₈ comprennent du carbone ou de l'azote ;
dans laquelle R₁, R₂, R₃, et R₄ représentent indépendamment une mono, di, tri ou tétra substitution ;
dans laquelle R₁ est éventuellement fusionné, R₂ est éventuellement fusionné au cycle B, R₃ est éventuellement fusionné au cycle C, et R₄ est éventuellement fusionné au cycle D ;
dans laquelle R₃ et R₄ sont éventuellement reliés pour former un cycle ;
dans laquelle si L₂ n'est pas une liaison simple, R₃ et L₂ ou R₄ et L₂ sont éventuellement reliés pour former un cycle ; et
dans laquelle R, R', R₁, R₂, R₃, et R₄ sont indépendamment sélectionnés parmi le groupe constitué d'hydrogène, deutérium, halogénure, alkyle, cycloalkyle, hétéroalkyle, arylalkyle, alkoxy, aryloxy, amino, silyl, alkényle, cycloalkényle, hétéroalkényle, alkynyle, aryle, hétéroaryle, acyle, carbonyle, acides carboxyliques, ester, nitrile, isonitrile, sulfanyle, sulfinyle, sulfonyle, phosphino, et de combinaisons de ceux-ci ;

2. Composé selon la revendication 1, dans lequel le composé possède une charge neutre.

3. Composé selon la revendication 1, dans lequel au moins deux de Z₁, Z₂, Z₃, et Z₄ sont des atomes d'azote.

4. Composé selon la revendication 1, dans lequel au moins deux de Z₁, Z₂, Z₃, et Z₄ sont des atomes de carbone.

5. Composé selon la revendication 1, dans lequel au moins l'un du cycle B, du cycle C, et du cycle D comprend un ligand carbène coordonné à Pt.

6. Composé selon la revendication 1, dans lequel au moins l'un de Z₁, A₁, A₂, A₃, A₄, A₅, A₆, A₇, et A₈ est un atome d'azote.

7. Composé selon la revendication 1, étant représenté par la formule :

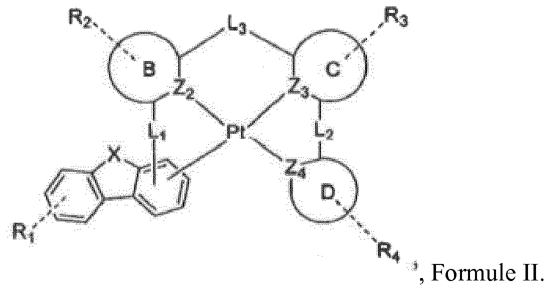

8. Composé selon la revendication 7, étant représenté par la formule :

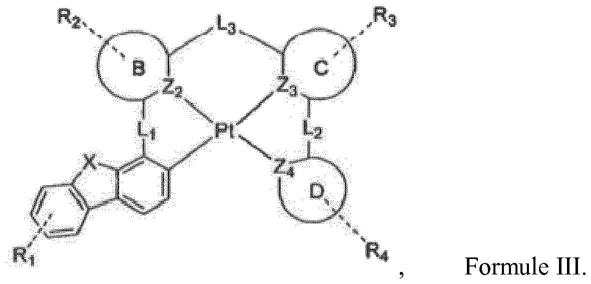

9. Composé étant représenté par la formule : 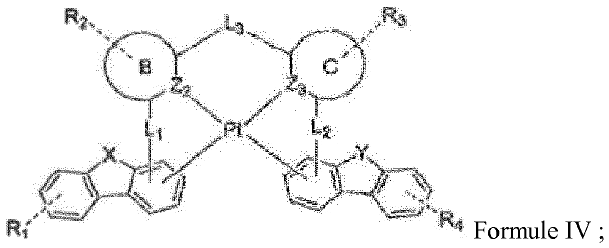 dans laquelle le cycle B et le cycle C sont des cycles aromatiques carbocycliques ou hétérocycliques à 5 ou 6 éléments ;
dans laquelle L₁, L₂, et L₃ sont indépendamment sélectionnés parmi le groupe constitué d'une liaison simple, BR, NR, PR, O, S, Se, C=O, S=O, SO₂, CRR', SiRR', et GeRR' ;
dans laquelle au moins l'un de L₁, L₂, et L₃ n'est pas une liaison simple ;
dans laquelle X est sélectionné parmi le groupe constitué de BR, NR, PR, O, S, Se, C=O, S=O, SO₂, CRR', SiRR', et GeRR' ;
dans laquelle Z₂ et Z₃ sont des atomes d'azote ou de carbone ;
dans laquelle R₁, R₂, R₃, et R₄ représentent indépendamment une mono, di, tri ou tétra substitution ;
dans laquelle R₁ est éventuellement fusionné, R₂ est éventuellement fusionné au cycle B, R₃ est éventuellement fusionné au cycle C, et R₄ est éventuellement fusionné au cycle D ;
dans laquelle R₃ et R₄ sont éventuellement reliés pour former un cycle ;
dans laquelle si L₂ n'est pas une liaison simple, R₃ et L₂ ou R₄ et L₂ sont éventuellement reliés pour former un cycle ; et
dans laquelle R, R', R₁, R₂, R₃, et R₄ sont indépendamment sélectionnés parmi le groupe constitué d'hydrogène, deutérium, halogénure, alkyle, cycloalkyle, hétéroalkyle, arylalkyle, alkoxy, aryloxy, amino, silyl, alkényle, cycloalkényle, hétéroalkényle, alkynyle, aryle, hétéroaryle, acyle, carbonyle, acides carboxyliques, ester, nitrile, isonitrile, sulfanyle, sulfinyle, sulfonyle, phosphino, et combinaisons de ceux-ci ; et
dans laquelle Y est sélectionné parmi le groupe constitué de BR, NR, PR, O, S, Se, C=O, S=O, SO₂, CRR', SiRR', et GeRR'.

10. Composé selon la revendication 9, étant représenté par la formule :

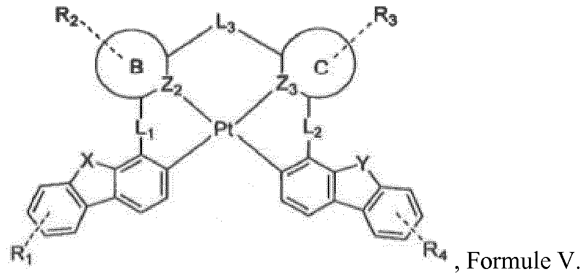

11. Composé selon la revendication 1, dans lequel L₁ et L₂ sont des liaisons simples.

12. Composé selon la revendication 1, dans lequel L₃ est indépendamment sélectionné parmi le groupe constitué de O, S, et NR.

13. Composé selon la revendication 1, dans lequel Z₂ et Z₃ sont des atomes d'azote.

14. Composé selon la revendication 1, dans lequel Z₂ et Z₄ sont des atomes d'azote.

15. Composé selon les revendications 1 et 9, dans lequel le composé est sélectionné parmi le groupe constitué de : 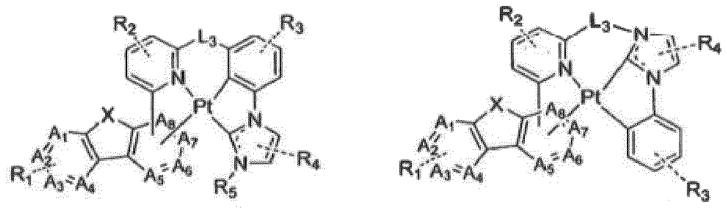 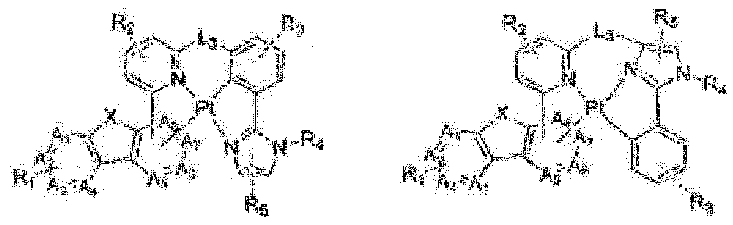 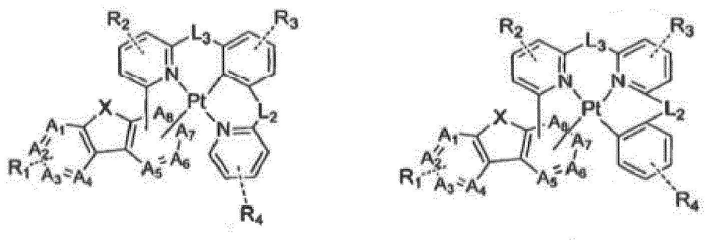 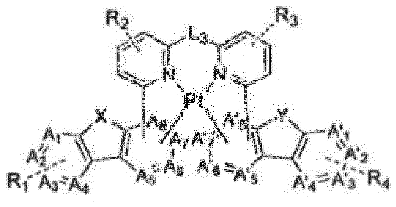 dans lequel Y est sélectionné parmi le groupe constitué de BR, NR, PR, O, S, Se, C=O, S=O, SO₂, CRR', SiRR', et GeRR' ;
dans lequel A₁', A₂', A₃', A₄', A₅', A₆', A₇', et A₈' comprennent du carbone ou de l'azote ;
dans lequel au plus l'un de A₁, A₂, A₃, A₄ est de l'azote;
dans lequel au plus l'un de A₅, A₆, A₇, A₈ est de l'azote, et l'azote n'est pas lié à Pt ;
dans lequel au plus l'un de A₁', A₂', A₃', A₄' est de l'azote;
dans lequel au plus l'un de A₅', A₆', A₇', A₈' est de l'azote, et l'azote n'est pas lié à Pt ;
dans lequel Pt forme au moins deux liaisons Pt-C ;
dans lequel R₃ et R₄ peuvent être fusionnés pour former un cycle ;
dans lequel R₅ est sélectionné parmi le groupe constitué d'hydrogène, deutérium, halogénure, alkyle, cycloalkyle, hétéroalkyle, arylalkyle, alkoxy, aryloxy, amino, silyl, alkényle, cycloalkényle, hétéroalkényle, alkynyle, aryle, hétéroaryle, acyle, carbonyle, acides carboxyliques, ester, de nitrile, isonitrile, sulfanyle, sulfinyle, sulfonyle, phosphino, et de combinaisons de ceux-ci ;

16. Premier dispositif comprenant un premier dispositif organique émetteur de lumière, comprenant en outre :
une anode ;
une cathode ; et
une couche organique, située entre l'anode et la cathode, comprenant un composé tel que défini dans l'une quelconque des revendications précédentes.
